# EUROPEAN PATENT SPECIFICATION

(11) **EP 3 854 622 B1**
(45) Date of publication and mention of the grant of the patent: **21.02.2024**
(21) Application number: 21161984.6
(22) Date of filing: 27.08.2012
(51) Int. Cl.: B60L 1/00, B60L 50/40, B60L 53/16, B60L 3/00, B60L 3/04, B60L 53/18, B60L 53/65, B60L 53/66, B60L 55/00, H02J 7/00

(54) **METHOD FOR IDENTIFYING OPERATING MODE OF CHARGING/SUPPLYING SYSTEM BETWEEN VEHICLE AND EXTERIOR, AND SYSTEM FOR IDENTIFYING OPERATING MODE OF THE SYSTEM BY THE IDENTIFYING METHOD**
VERFAHREN ZUM ERKENNEN DER BETRIEBSART EINES AUFLADUNGS/VERSORGUNGSSYSTEMS FÜR EIN FAHRZEUG, UND SYSTEM ZUM ERKENNEN DER BETRIEBSART DURCH DAS VERFAHREN
PROCÉDÉ POUR IDENTIFIER UN MODE DE FONCTIONNEMENT DE SYSTÈME DE CHARGE/ALIMENTATION ENTRE UN VÉHICULE ET L'EXTÉRIEUR, ET SYSTÈME POUR IDENTIFIER UN MODE DE FONCTIONNEMENT DU SYSTÈME PAR LE PROCÉDÉ D'IDENTIFICATION

(30) Priority: 30.08.2011 JP 2011186934
(43) Date of publication of application: 28.07.2021
(62) Divisional of application: 12788252.0
(73) Proprietor: TOYOTA JIDOSHA KABUSHIKI KAISHA, Toyota-shi, Aichi-ken, 471-8571 (JP)
(72) Inventor: ICHIKAWA, Shinji, Toyota-shi, Aichi-ken, 471-8571 (JP); SAWADA, Hiroki, Toyota, Aichi, 470-0334 (JP); SUZUKI, Yasuo, Toyota, Aichi, 470-0334 (JP); NIIKAWA, Yuka, Toyota, Aichi, 470-0334 (JP)
(74) Representative: Winter, Brandl - Partnerschaft mbB

(56) References cited:
- WO-A1-2011/077505
- JP-A- 2010 148 247
- US-A1- 2008 052 145
- US-A1- 2010 145 885
- US-A1- 2010 164 287
- US-A1- 2011 202 192

## Description

### BACKGROUND OF THE INVENTION

### 1. Field of the Invention

The invention relates to an identifying method for identifying an operating mode of a charging/supplying system operable in a selected one of a charging mode in which an electric storage device installed on a vehicle is charged with electric power from an external power-supplying device as a first external device to the electric storage device, and a supplying mode in which electric power is supplied from the vehicle to an external power-supplied device as a second external device, in the case where a common connection portion (e.g., an inlet of the vehicle) is used in both of the charging mode and the supplying mode. The invention also relates to an identifying system for identifying the operating mode of the charging/supplying system by the same method.

### 2. Description of Related Art

An electrically powered vehicle is installed with an electric storage device (e.g., a secondary battery or a capacitor), and is adapted to run, using driving force generated from a driving power source (e.g., a motor) that is driven with electric power stored in the electric storage device. Examples of the electrically powered vehicle include an electric vehicle (EV), a hybrid vehicle (HV), and so forth.

In connection with the electrically powered vehicle, a technology of charging the electric storage device installed on the electrically powered vehicle, by means of a commercial power supply (e.g., a source of a relatively low voltage of 100V or 200V) that supplies electric power to each home, for example, has already been developed. In the following description, the vehicle in which the electric storage device (e.g., a battery) installed on the vehicle can be charged by means of an external power supply outside the vehicle may be called "plug-in vehicle" when appropriate.

In a hybrid vehicle (HV), a motor that normally functions as a driving power source may be driven as a generator, by an internal combustion engine installed on the HV or through regenerative braking, for example, so as to charge the electric storage device installed on the HV. The electric storage device may also be charged with electric power from the external power supply as described above. The HV of this type may also be called "plug-in hybrid vehicle (PHV)".

In the meantime, it has been proposed to supply electric power from the electric storage device installed on the electrically powered vehicle as described above, to an external power-supplied device (e.g., a power supply or an electric load), in order to make efficient use of electric power from an environmental viewpoint, or alleviate power shortage in times of disaster, for example. In other words, it has been proposed to use the electric storage device installed on the electrically powered vehicle, as a power-supplying device for supplying electric power to the external power-supplied device.

In this case, a power-supplying mechanism for supplying electric power from the electric storage device installed on the electrically powered vehicle to the external power-supplied device may be provided separately from or independently of a charging mechanism for charging the storage device by supplying electric power from an external power-supplying device (e.g., a commercial power supply) to the storage device installed on the electrically powered vehicle. However, providing the power-supplying mechanism in addition to the charging mechanism may incur various problems, such as increase in the size of the vehicle, increase in complexity of the supplying/charging mechanism, and increase in the manufacturing cost of the vehicle.

Thus, in the technical field concerned, various technologies have been proposed which enable a single mechanism to supply electric power from the vehicle to the external power-supplied device and also charge the storage device installed on the vehicle with electric power from the external power-supplying device, by switching the mechanism between the two modes of operation.

For example, an electric power management system that permits electric power to be transmitted between a battery of an electric vehicle and a house is described in, for example, Japanese Patent Application Publication No. 2001-008380 (JP 2001-008380 A). In this system, a house-side main controller determines whether a charge mode or a discharge mode is to be established, and a charge/discharge control signal is transmitted from a house-side charge/discharge controller to a vehicle-side battery controller via a communications antenna, and charge control or discharge control is performed in the vehicle, based on the charge/discharge control signal received via the communications antenna.

In the meantime, as one of standards for electric vehicles having on-board batteries that can be charged with electric power from houses, the Society of Automotive Engineers (SAE) in the U.S. has established "SAE Electric Vehicle Conductive Charge Coupler" ("SAE Electric Vehicle Conductive Charge Coupler" (US), SAE Standards, SAE international, Nov. 2001). In Japan, too, "General Requirements for Electric Vehicle Conductive Charging System" ("General Requirement for Electric Vehicle Conductive Charging System", Japan Electric Vehicle Association Standard, March 29, 2001) is established.

In the "SAE Electric Vehicle Conductive Charge Coupler" (US), SAE Standards, SAE international, Nov. 2001, and the "General Requirements for Electric Vehicle Conductive Charging System", Japan Electric Vehicle Association Standard, March 29, 2001, standards concerning a control pilot are set or defined. The control pilot is defined as a control line that connects a control circuit of EVSE (Electric Vehicle Supply Equipment) that supplies electric power from house or indoor wiring to a vehicle, with a ground portion of the vehicle, via a vehicle-side control circuit. In operation, a connecting condition of a charging cable, the feasibility of supplying electric power from the power supply to the vehicle, the rated current of the EVSE, etc. are determined, based on a CPLT (Control Pilot Line Transmission) signal (pilot signal) transmitted via the control line.

In a vehicle charge/discharge system capable of charging the electric storage device installed on the vehicle with electric power from a power supply outside the vehicle and also capable of supplying electric power from the storage device to a power supply or electric load outside the vehicle, it has been proposed to cause a signal generating circuit provided in the charge/discharge system to generate a control signal (CPLT signal) from which it can be determined whether a power cable connected to the vehicle is a charging cable or a supplying cable, and cause a control device installed on the vehicle to control a power conversion device in either of the charging mode and the supplying mode, according to the control signal transmitted from the signal generating circuit (see, for example, Japanese Patent Application Publication No. 2010-035277 (JP 2010-035277 A)). Further, US 2011 / 0202192 A1 discloses a communication between the electric vehicle equipment, which is formed in an electric vehicle, and the electric vehicle station equipment. The EVE includes a vehicle link that provides a link from outside entities to components of the electric vehicle. The VL controls charging and discharging of a battery of the electric vehicle. US 2008 / 0052145 A1 also discloses a power aggregation system for distributed electric resources and associated methods.

However, when it is determined only based on the particular control signal as described above whether the operating mode to be established is the charging mode or the supplying mode, the operating mode may be erroneously determined because the particular control signal is not correctly detected for some reason, such as breakage of a signal channel that transmits the control signal, a failure or malfunction of a detecting means for detecting the control signal, or increase of contact resistance due to poor contact between the connecting portion (e.g., an inlet) and the connector or age-related deterioration.

If the operating mode is erroneously determined, problems, such as a failure to charge the electric storage device installed on the vehicle with electric power from the external power-supplying device, or a failure to supply electric power from the vehicle to an external power-supplied device, may occur. In other cases, charging of the storage device using the external power-supplying device and supplying of electric power from the vehicle to the external power-supplied device may be carried out at the same time, which may result in electrical short circuit between the vehicle and the external power-supplying device, and thus incur situations, such as breakage, burning, etc. of the external power-supplying device and the electric storage device and power generating device installed on the vehicle.

As described above, in the technical field concerned, there exists a continuing demand for a technology with which it can be reliably determined whether the operating mode of a system that permits electric power to be transmitted between the vehicle and the exterior thereof is the charging mode or the supplying mode.

### SUMMARY OF THE INVENTION

The present invention has been developed in order to meet the above demand. More specifically, the invention provides identifying method and identifying system for reliably determining whether an operating mode of a system that permits electric power to be transmitted between a vehicle and an exterior thereof is a charging mode or a supplying mode.

According to one aspect of the invention, an identifying method is provided for identifying an operating mode of a charging/supplying system. In the identifying method a plurality of detection values from at least one electric connection channel provided between a vehicle and a first external device or a second external device via a connecting portion is detected, in the charging/supplying system in which the vehicle is connected with the first external device or the second external device via the connecting portion used in common in a charging mode in which an electric storage device installed on the vehicle is charged with electric power from the first external device to the electric storage device and a supplying mode in which electric power is supplied from the vehicle to the second external device. The charging/supplying system is configured to be operated in a selected one of the charging mode and the supplying mode. In the identifying method it is further determined whether the operating mode of the charging/supplying system is the charging mode or the supplying mode, based on a combination of the plurality of detection values. The plurality of detection values include at least two detection values selected from:
a detection value corresponding to the presence or absence of a voltage applied from the first external device to the vehicle, the detection value being detected in an electric power channel provided between the vehicle and the first external device or provided between the vehicle and the second external device;
a detection value corresponding to the presence or absence of PLC communication detected in the electric power channel provided between the vehicle and the first external device or provided between the vehicle and the second external device;
a detection value of a signal transmitted by the PLC communication detected in the electric power channel provided between the vehicle and the first external device or provided between the vehicle and the second external device;
a detection value of a control signal representing a condition of fit of a connector that connects the vehicle with the first external device or the second external device, the detection value being detected in a signal channel provided between the vehicle and the first external device or provided between the vehicle and the second external device;
a detection value of a control signal representing a connecting condition of a cable that connects the first external device with the vehicle, the detection value being detected in the signal channel provided between the vehicle and the first external device or provided between the vehicle and the second external device;
a detection value of a control signal representing a feasibility of supplying electric power from the first external device to the vehicle, the detection value being detected in the signal channel provided between the vehicle and the first external device or provided between the vehicle and the second external device; and
a detection value of a control signal representing a rated current of the first external device, the detection value being detected in the signal channel provided between the vehicle and the first external device or provided between the vehicle and the second external device. The operating mode includes a third operating mode, which is not the charging mode nor the supplying mode. The third operating mode is a power stop mode in which neither the charging mode nor the supplying mode is implemented. The identifying method further comprises the step of determining that the operating mode of the charging/ supplying system is a power stop mode when the voltage applied from the first external device to the vehicle is not detected.

According to another aspect of the invention, an identifying system having a connector, a detector and an identifying device is provided. The connector connects a vehicle with a first external device or a second external device via a connecting portion used in common in a charging mode in which an electric storage device installed on the vehicle is charged with electric power from the first external device to the electric storage device and a supplying mode in which electric power is supplied from the vehicle to the second external device. The detector detects a plurality of detection values from at least one electric connection channel provided between the vehicle and the first external device or the second external device via the connecting portion. The identifying device determines whether the operating mode of the charging/supplying system, in which the charging/supplying system is operable in a selected one of the charging mode and the supplying mode, is the charging mode or the supplying mode, based on a combination of the plurality of detection values. The plurality of detection values include at least two detection values selected from:
a detection value corresponding to the presence or absence of a voltage applied from the first external device to the vehicle, the detection value being detected in an electric power channel provided between the vehicle and the first external device or provided between the vehicle and the second external device;
a detection value corresponding to the presence or absence of PLC communication detected in the electric power channel provided between the vehicle and the first external device or provided between the vehicle and the second external device;
a detection value of a signal transmitted by the PLC communication detected in the electric power channel provided between the vehicle and the first external device or provided between the vehicle and the second external device;
a detection value of a control signal representing a condition of fit of a connector that connects the vehicle with the first external device or the second external device, the detection value being detected in a signal channel provided between the vehicle and the first external device or provided between the vehicle and the second external device;
a detection value of a control signal representing a connecting condition of a cable that connects the first external device with the vehicle, the detection value being detected in the signal channel provided between the vehicle and the first external device or provided between the vehicle and the second external device;
a detection value of a control signal representing a feasibility of supplying electric power from the first external device to the vehicle, the detection value being detected in the signal channel provided between the vehicle and the first external device or provided between the vehicle and the second external device; and
a detection value of a control signal representing a rated current of the first external device, the detection value being detected in the signal channel provided between the vehicle and the first external device or provided between the vehicle and the second external device. The operating mode includes a third operating mode, which is not the charging mode nor the supplying mode. The third operating mode is a power stop mode in which neither the charging mode nor the supplying mode is implemented. The identifying system is configured to determining that the operating mode of the charging/ supplying system is a power stop mode when the voltage applied from the first external device to the vehicle is not detected.

With the identifying method and the identifying system as described above, it can be reliably determined whether the operating mode is the charging mode or the supplying mode, in the system that permits electric power to be transmitted between the vehicle and the exterior thereof.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a schematic view useful for explaining the configuration of an identifying system according to one embodiment of the invention; and
FIG. 2 is a flowchart illustrating the flow of various operations performed in an identifying method according to one embodiment of the invention.

### DETAILED DESCRIPTION OF EMBODIMENTS

As described above, the invention provides identifying method and system for reliably determining whether the operating mode of the system that permits electric power to be transmitted between the vehicle and the exterior thereof is the charging mode or the supplying mode.

Having made an intensive study, the inventor of this invention found that the determination as to which of the charging mode and the supplying mode is established is not made only based on a particular control signal, but based on a combination of a plurality of detection values detected from at least one electric connection channel provided between the vehicle and external devices, so that it can be determined with improved reliability which of the charging mode and the supplying mode is established. On the basis of the founding, the inventor reached the present invention.

A first example of the invention is an identifying method for identifying an operating mode of a charging/supplying system in which a vehicle is connected with an external power-supplying device as a first external device or an external power-supplied device as a second external device via a connecting portion used in common in a charging mode in which an electric storage device installed on the vehicle is charged with electric power from the first external device to the electric storage device and a supplying mode in which electric power is supplied from the vehicle to the second external device, the charging/supplying system being operable in a selected one of the charging mode and the supplying mode. The identifying method is characterized in that a plurality of detection values are detected from at least one electric connection channel provided between the vehicle and the first external device or the second external device via the connecting portion, and that it is determined whether the operating mode of the charging/supplying system is the charging mode or the supplying mode, based on a combination of the above-indicated plurality of detection values.

As described above, the identifying method according to this example is a method for identifying the operating mode of the charging/supplying system in which the vehicle is connected with the first external device or the second external device via the connecting portion used in common in the charging mode in which the electric storage device installed on the vehicle is charged with electric power from the first external device and the supplying mode in which electric power is supplied from the vehicle to the second external device, the charging/supplying system being operable in a selected one of the charging mode and the supplying mode.

The above-mentioned vehicle means a vehicle installed with an electric storage device (e.g., a secondary battery or a capacitor), and, more specifically, represents an electrically powered vehicle, such as a plug-in hybrid vehicle (PHV) or an electric vehicle (EV). The electric storage device installed on the vehicle is adapted to be charged with electric power supplied from the first external device, and the vehicle is generally provided with a connecting portion (e.g., an inlet) to which a charging connector, or the like, that connects the vehicle with the first external device is adapted to be fitted. As a matter of course, the charging connector is electrically connected to the first external device, via a cable, or the like.

It is also possible to supply electric power from the vehicle to a second external device. In this embodiment, when electric power is supplied from the vehicle to the second external device, a supplying connector, or the like, that connects the vehicle with the second external device is fitted to the connecting portion. Namely, in this example, the common connecting portion is used in both of the operating modes, i.e., the charging mode in which the electric storage device installed on the vehicle is charged with electric power from the first external device, and the supplying mode in which electric power is supplied from the vehicle to the second external device. As a matter of course, the supplying connector is electrically connected to the second external device, via a cable, or the like.

In this example, the first external device means a device that supplies electric power to the vehicle so as to charge the electric storage device (e.g., a secondary battery or a capacitor) installed on the vehicle. Examples of the first external device include, for example, a commercial power supply that supplies electric power to each home, and a charging station. Also, the second external device means a device that receives electric power supplied from the vehicle, and examples of the second external device include, for example, an electric load, such as home electric appliances, a power supply and a power network.

Accordingly, the vehicle is provided with the charging/supplying system in which the vehicle is connected with the first external device or the second external device via the connecting portion used in common in the charging mode in which the electric storage device installed on the vehicle is charged using the first external device and the supplying mode in which electric power is supplied from the vehicle to the second external device, the charging/supplying system being operable in a selected one of the charging mode and the supplying mode.

The charging/supplying system may include, for example, a power conversion mechanism (e.g., an AC-DC converter) for converting electric power supplied from the first external device into a condition appropriate for charging of the electric storage device installed on the vehicle, or converting electric power generated by a power generating device (e.g., a generator, a motor that also functions as a generator, or regenerative braking) or electric power stored in the storage device into a condition appropriate for supplying of power to the second external device.

The charging/supplying system may further include various mechanisms. The mechanisms include, for example, an electric power channel through which electric power is supplied between the vehicle and the first external device or second external device, a signal channel(s) that transmits control signals representing a condition of fit of a connector that connects the vehicle with the first external device or second external device, a connecting condition of a cable, the feasibility of supplying electric power from the first external device to the vehicle, and the rated current of the first external device, for example, detecting means (e.g., various sensors, such as a voltage sensor) for detecting various control signals transmitted via the electric power channel and the signal channel(s), and a control means for switching the operating mode between the charging mode and the supplying mode based on various detection values detected by the detecting means.

The control means may be in the form of an electronic control unit (ECU) including a central processing unit (CPU), a data storage device or devices (e.g., read-only memory (ROM), random access memory (RAM), hard disk drive (HDD), non-volatile memory, and volatile memory), and data input/output ports, for example. It is to, however, to be understood that the above explanation concerning the configuration of the charging/supplying system is merely exemplary, and the configuration of the charging/supplying system should not be limited to the above description.

As described above, the identifying method according to this example is a method for identifying the operating mode of the charging/supplying system. More specifically, in the identifying method of this example, a plurality of detection values are detected from at least one electric connection channel provided between the vehicle and the first external device or the second external device via the connecting portion, and it is determined whether the operating mode of the charging/supplying system is the charging mode or the supplying mode, based on a combination of the above-indicated plurality of detection values.

The electric connection channel means an electric connection channel that electrically connects the vehicle with the first external device or the second external device, such as an electric power channel through which electric power is supplied between the vehicle and the first external device or the second external device, and a signal channel through which various control signals are transmitted between the vehicle and the first external device or the second external device. The electric connection channel may further include an electric connection channel formed between a connector for connecting the vehicle with the first external device or second external device and the vehicle, and an electric connection channel formed between a connection portion to which the connector is fitted and the control device or detecting means provided in the vehicle.

More specifically, in the identifying method of this example, the detecting means (e.g., various sensors, such as a voltage sensor) provided in the electric connection channels as described above detects or obtains a plurality of detection values corresponding to a voltage or current of electric power supplied via the electric power channel, and various control signals transmitted via the signal channel(s), and the ECU (e.g., a power control device PM-ECU) including CPU, data storage device(s), data input/output ports, etc. determines whether the operating mode of the charging/supplying system is the charging mode or the supplying mode, based on a combination of the plurality of detection values.

A process of determining whether the operating mode of the charging/supplying system is the charging mode or the supplying mode is stored, in the form of a program that causes the CPU to execute the process, in the above-described data storage device, for example. It is, however, to be understood that the above description is merely exemplary, and that this embodiment should not be construed as being limited to the above description.

In the identifying method according to this example, it is determined whether the operating mode of the charging/supplying system is the charging mode or the supplying mode, based on the combination of the plurality of detection values. However, a third operating mode, which is not the charging mode nor the supplying mode, is further included as an additional choice of the operating mode of the charging/supplying system. More specifically, the third operating mode is a power stop mode in which neither the charging mode nor the supplying mode is implemented.

The operating mode of the charging/supplying system corresponding to each of various combinations of the plurality of detection values may be determined as appropriate, in view of the construction or configuration and conditions of use of the vehicle, a first external device, a second external device, and the charging/supplying system, and the severity of a problem that is presumed to happen when the operating mode of the charging/supplying system is erroneously determined due to erroneous detection of one or more of the individual detection values, for example.

As described above, in the identifying method of this example, the determination as to whether the operating mode is the charging mode or the supplying mode is not made only based on a detection value of a particular control signal, or the like, but is made based on a combination of a plurality of detection values detected or obtained from at least one electric connection channel provided between the vehicle and the first external device or second external device. In this manner, a risk of erroneously determining the operating mode of the charging/supplying system can be reduced, even when the particular control signal is not correctly detected for some reason, such as breakage of a signal channel that transmits a control signal, a failure or malfunction of a detecting means for detecting the control signal, or increase of contact resistance due to poor contact between the connecting portion (e.g., an inlet) and the connector, or age-related deterioration, for example.

As described above, if the operating mode is erroneously determined, a problem, such as a failure to charge the electric storage device installed on the vehicle with electric power from the first external device, or a failure to supply electric power from the vehicle to the second external device, may occur. In other cases, charging of the storage device using the first external device and supplying of electric power from the vehicle to the second external device may be carried out at the same time, which may result in electrical short circuit between the vehicle and the first external device, and thus incur situations, such as breakage, burning, etc. of the first external device and the electric storage device and power generating device installed on the vehicle. However, according to the identifying method of this example, it can be reliably determined whether the operating mode is the charging mode or the supplying mode, in the system that permits electric power to be transmitted between the vehicle and the exterior thereof; therefore, the above-described problems are less likely to occur or prevented from occurring.

As described above, in the identifying method according to this example, a plurality of detection values are detected from at least one electric connection channel provided between the vehicle and the first external device or the second external device via the connecting portion, and it is determined whether the operating mode of the charging/supplying system is the charging mode or the supplying mode, based on a combination of the plurality of detection values. The plurality of detection values may be obtained by causing the detecting means placed in the electric connection channels, such as the electric power channel through which electric power is supplied between the vehicle and the first external device or second external device, and the signal channel(s) through which various control signals are transmitted between the vehicle and the first external device or second external device, to detect the voltage or current of electric power supplied via the electric power channel, and various control signals transmitted via the signal channel(s), as described above.

More specifically, the above-indicated plurality of detection values may include a detection value corresponding to the presence or absence of a voltage applied from the first external device to the vehicle, which is detected in the electric power channel provided between the vehicle and the first external device or second external device for permitting electric power to be supplied between the vehicle and the first external device or second external device.

The plurality of detection values may also include a detection value corresponding to the presence or absence of PLC (Power Line Communication) communication detected in the electric power channel provided between the vehicle and the first external device or second external device for permitting electric power to be supplied between the vehicle and the first external device or second external device, and a detection value of a signal transmitted by the PLC communication.

The plurality of detection values may further include a detection value of a control signal representing a condition of fit of a connector that connects the vehicle with the first external device or the second external device, which is detected in a signal path provided between the vehicle and the first external device or the second external device.

The plurality of detection values may further include a detection value of a control signal representing a connecting condition of a cable that connects the first external device with the vehicle, the feasibility of supplying electric power from the first external device to the vehicle, or the rated current of the first external device, which is detected in a signal channel provided between the vehicle and the first external device or second external device.

Thus, in the identifying method according to the the invention, the plurality of detection values include at least two detection values selected from a detection value corresponding to the presence or absence of a voltage applied from the first external device to the vehicle, which is detected in the electric power channel provided between the vehicle and the first external device or the second external device, a detection value corresponding to the presence or absence of PLC (Power Line Communication) communication detected in the electric power channel provided between the vehicle and the first external device or the second external device and a detection value of a signal transmitted by the PLC communication, a detection value of a control signal representing a condition of fit of a connector that connects the vehicle with the first external device or the second external device, which is detected in a signal path provided between the vehicle and the first external device or the second external device, and a detection value of a control signal representing a connecting condition of a cable that connects the first external device with the vehicle, the feasibility of supplying electric power from the first external device to the vehicle, or the rated current of the first external device, which is detected in a signal channel provided between the vehicle and the first external device or the second external device.

In the identifying method according to this embodiment, the operating mode of the charging/supplying system may be determined, based on a combination of the detection value corresponding to the presence or absence of a voltage applied from the first external device to the vehicle, which is detected in the electric power channel provided between the vehicle and the first external device or second external device for permitting electric power to be supplied between the vehicle and the first external device or second external device, and at least one of the other detection values.

If a voltage applied from the first external device to the vehicle is detected in the electric power channel provided between the vehicle and the first external device or second external device for permitting electric power to be supplied between the vehicle and the first external device or second external device, it means that the first external device is connected to the vehicle, and electric power for charging the electric storage device installed on the vehicle is supplied from the first external device to the vehicle.

In the above case, if the operating mode of the charging/supplying system is erroneously set to the supplying mode, electrical short circuit may occur to the power conversion mechanism installed on the vehicle or the first external device, for example, and various components or units that constitute the system that permits electric power to be transmitted between the vehicle and the exterior may suffer from problems, such as failure, breakage, and burning. Accordingly, when a voltage applied from the first external device to the vehicle is detected in the electric power channel, the operating mode of the charging/supplying system should be set to the charging mode.

However, in some cases, the detection of the voltage applied from the first external device to the vehicle may be erroneous detection due to some cause, such as breakage of the electric connection channel, failure or malfunction of the detecting means, or increase in the contact resistance due to poor contact between electric contacts or age-related deterioration, and the first external device is not actually connected to the vehicle. In such a case, even if the operating mode of the charging/supplying system is set to the charging mode, only based on the detection value, the electric storage device installed on the vehicle may not be charged since the first external device is not actually connected to the vehicle.

On the other hand, if no voltage applied from the first external device to the vehicle is detected in the electric power channel provided between the vehicle and the first external device or second external device for supplying electric power between the vehicle and the first external device or second external device, it means that the first external device is not connected to the vehicle, and electric power for charging the electric storage device installed on the vehicle is not supplied from the first external device to the vehicle.

In the above case, if the operating mode of the charging/supplying system is erroneously set to the charging mode, the electric storage device installed on the vehicle may not be charged since electric power is not actually supplied from the first external device to the vehicle. Accordingly, when no voltage applied from the first external device to the vehicle is detected in the electric power channel, the operating mode of the charging/supplying system should be set to the supplying mode (or power stop mode).

However, in some cases, the detection of the absence of voltage applied from the first external device to the vehicle may be erroneous detection due to some cause, and the first external device may be actually connected to the vehicle. In this case, if the operating mode of the charging/supplying system is set to the supplying mode, only based on the detection value, electrical short circuit may occur to the power conversion mechanism installed on the vehicle or the first external device, for example, and various components or units that constitute the system that permits electric power to be transmitted between the vehicle and the exterior may suffer from problems, such as failure, breakage, and burning.

According to the identifying method of this embodiment, the operating mode of the charging/supplying system is determined, based on not only the detection value corresponding to the presence or absence of a voltage applied from the first external device to the vehicle, which is detected in the electric power channel provided between the vehicle and the first external device or second external device for permitting electric power to be supplied between the vehicle and the first external device or second external device, but based on a combination of the detection value and at least one of the other detection values. Thus, according to the identifying method of this embodiment, the erroneous determination as described above is prevented, and the operating mode of the charging/supplying system can be determined with high reliability.

In the identifying method according to this embodiment, the operating mode of the charging/supplying system may be determined, based on a combination of the detection value corresponding to the presence or absence of PLC communication detected in the electric power channel provided between the vehicle and the first external device or second external device for permitting electric power to be supplied between the vehicle and the first external device or second external device, the detection value of a signal transmitted by the PLC communication, and at least one of the other detection values.

In this connection, the PLC denotes a communications technology for sending a signal while carrying it on electric wiring (electric power channel) through which electric power is supplied, and this technology makes it possible to send various signals in various modulation methods via the electric power channel. In this embodiment, for example, a control signal as a command to operate the charging/supplying system in the charging mode or the supplying mode may be transmitted from the first external device or the second external device to the vehicle via the electric power channel.

In the case where a PLC signal is detected in the electric power channel provided between the vehicle and the first external device or second external device for permitting electric power to be supplied between the vehicle and the first external device or second external device, and the PLC signal is a control signal as a command to operate the charging/supplying system in the charging mode, if the operating mode of the charging/supplying system is erroneously set to the supplying mode, electrical short circuit may occur to the power conversion mechanism installed on the vehicle or the first external device, for example, and various components or units that constitute the system that permits electric power to be transmitted between the vehicle and the exterior may suffer from problems, such as failure, breakage, and burning. Accordingly, if a PLC signal is detected in the electric power channel, and the PLC signal is a control signal as a command to operate the charging/supplying system in the charging mode, the operating mode of the charging/supplying system should be set to the charging mode.

However, in some cases, the result of detection of the PLC signal in the electric power channel may be based on erroneous detection due to some cause. In this case, even if the operating mode of the charging/supplying system is set to the charging mode only based on the result of detection, the first external device may not be actually connected to the vehicle, and the electric storage device installed on the vehicle may not be charged with electric power from the first external device.

On the other hand, if the operating mode of the charging/supplying system is erroneously set to the charging mode when a PLC signal is detected in the electric power channel and the PLC signal is a control signal as a command to operate the charging/supplying system in the supplying mode, electric power may not be supplied from the vehicle to the second external device since the charging/supplying system operates erroneously in the charging mode, even though the second external device is connected to the vehicle, and electric power should be supplied from the vehicle to the second external device. Accordingly, when a PLC signal is detected in the power channel, and the PLC signal is a control signal as a command to operate the charging/supplying system in the supplying mode, the operating mode of the charging/supplying system should be set to the supplying mode.

However, in some cases, the result of detection of the PLC signal in the electric power channel may be based on erroneous detection due to some cause. In this case, if the operating mode of the charging/supplying system is set to the supplying mode, only based on the result of detection, electrical short circuit may occur to the power conversion mechanism installed on the vehicle or the first external device, for example, and various components or units that constitute the system that permits electric power to be transmitted between the vehicle and the exterior may suffer from problems, such as failure, breakage, and burning.

When no PLC signal is detected in the electric power channel, it cannot be determined, only based on the result of detection, whether the operating mode of the charging/supplying system should be set to the charging mode or should be set to the supplying mode. However, the situation where no PLC signal is detected in the electric power channel may be based on erroneous detection due to some cause. In this case, unless the operating mode of the charging/supplying system is specified and correctly switched, only based on the situation, charging of the electric storage device installed on the vehicle with electric power from the external first external device or supplying of electric power from the vehicle to the second external device may not be performed though it should have been done as originally intended.

However, according to the identifying method of this embodiment, the operating mode of the charging/supplying system is determined, not only based on the detection value corresponding to the presence or absence of the PLC communication detected in the electric power channel provided between the vehicle and the first external device or second external device for permitting electric power to be supplied between the vehicle and the first external device or second external device, and the detection value of a signal transmitted by the PLC communication, but based on a combination of these detection values and at least one of the other detection values. Thus, according to the identifying method of this embodiment, the erroneous determination as described above is prevented, and the operating mode of the charging/supplying system can be determined with high reliability.

In this embodiment, the operating mode of the charging/supplying system may be determined, based on a combination of the detection value of the control signal representing a condition of fit of the connector that connects the vehicle with the first external device or the second external device, which is detected in a signal path provided between the vehicle and the first external device or second external device, and at least one of the other detection values.

Here, the condition of fit of the connector means a condition of fit of a charging connector electrically connected with the first external device or a supplying connector electrically connected with the second external device, in the connecting portion used in common in the charging mode in which the electric storage device installed on the vehicle is charged with electric power from the first external device, and the supplying mode in which electric power is supplied from the vehicle to the second external device, or an electric connecting condition between a particular signal channel provided in each of the connectors and a corresponding signal channel of the connecting portion, for example.

More specifically, the condition of fit of the connector may be selected from, for example, a non-fit condition in which the connector and the connecting portion have not been fitted with each other, and the particular signal channel provided in the connector is not electrically connected with the corresponding signal channel of the connecting portion, a half-fit condition in which the particular signal channel provided in the connector is electrically connected with the corresponding signal channel of the connecting portion, but the connector and the connecting portion are not completely fitted with each other, and a complete-fit condition in which the particular signal channel provided in the connector is electrically connected with the corresponding signal channel of the connecting portion, and the connector and the connecting portion are completely fitted with each other.

The control signal representing the condition of fit of the connector may be detected via the particular signal channel by control means provided in the charging/supplying system, as a value of combined impedance (combined resistance) of the particular signal channel, for example. In this case, the status of electric connection of a resistor(s) placed in a portion of the particular signal channel which is included in the connector may be arranged to change in accordance with the condition of fit of the connector, for example, so that the combined impedance value (combined resistance value) of the particular signal channel takes different values corresponding to the respective conditions of fit of the connector as described above.

As a method of arranging the system so that the status of electric connection of the resistor(s) placed in a portion of the particular signal channel which is included in the connector changes in accordance with the condition of fit of the connector, a microswitch, or the like, which operates in conjunction with an operation to fit a protrusion of a lock mechanism provided on the connector in a corresponding recess of the connecting portion, may be used, so as to change the status of electric connection of the resistor(s) placed in the portion of the signal channel which is included in the connector. It is, however, to be understood that the method of arranging the system as described above is not limited to this method.

Also, the impedance of the particular signal channel may be obtained, for example, by applying a given voltage to a circuit including the particular signal channel, detecting a potential of the signal channel with a detecting means, and calculating the impedance of the signal channel based on the potential. It is, however, to be understood that the method of detecting the impedance of the particular signal channel is not limited to this method.

Further, the detection value of the control signal representing the condition of fit of the connector may be adapted to be different values depending on whether the connector fitted to the connecting portion is a charging connector or a supplying connector. For example, when the system is arranged so that the combined impedance (combined resistance) of the particular signal channel takes different values corresponding to the respective conditions of fit of the connector, the value of the combined impedance (combined resistance) of the particular signal channel corresponding to at least one of the various conditions of fit of the connector may be set to different ranges, depending on whether the connector fitted to the connecting portion is a charging connector or a supplying connector. With this arrangement, the control means provided in the charging/supplying system can easily determine whether the connector fitted to the connecting portion is a charging connector or a supplying connector.

In the case where it is determined, based on the detection value (e.g., combined resistance value) of the control signal representing a condition of fit of the connector that connects the vehicle with the first external device or second external device, which is detected in the signal channel provided between the vehicle and the first external device or second external device, that the charging/supplying system should operate in the charging mode, if the operating mode of the charging/supplying system is erroneously set to the supplying mode, electrical short circuit may occur to the power conversion mechanism installed on the vehicle or the first external device, and various components or units that constitute the system that permits electric power to be transmitted between the vehicle and the exterior may suffer from problems, such as failure, breakage, and burning. Accordingly, when it is determined, based on the detection value of the control signal representing the condition of fit of the connector, that the charging/supplying system should operate in the charging mode, the operating mode of the charging/supplying system should be set to the charging mode.

However, in some cases, the result of detection of the control signal representing the condition of fit of the connector may be based on erroneous detection due to some cause. In such cases, even if the operating mode of the charging/supplying system is set to the charging mode, only based on the result of detection, the first external device may not be actually connected to the vehicle, and the electric storage device installed on the vehicle may not be charged.

On the other hand, if the operating mode of the charging/supplying system is erroneously set to the charging mode when it is determined based on the detection value of the control signal representing the condition of fit of the connector that the charging/supplying system should operate in the supplying mode, electric power may not be supplied from the vehicle to the second external device since the charging/supplying system erroneously operates in the charging mode, though the second external device is connected to the vehicle, and electric power should be supplied from the vehicle to the second external device. Accordingly, when it is determined, based on the detection value of the control signal representing the condition of fit of the connector, that the charging/supplying system should operate in the supplying mode, the operating mode of the charging/supplying system should be set to the supplying mode.

However, in some cases, the result of detection of the control signal representing the condition of fit of the connector may be based on erroneous detection due to some cause. In such cases, if the operating mode of the charging/supplying system is set to the supplying mode, only based on the result of detection, electrical short circuit may occur to the power conversion mechanism installed on the vehicle or the first external device, for example, and various components or units that constitute the system that permits electric power to be transmitted between the vehicle and the exterior may suffer from problems, such as failure, breakage, and burning.

However, according to the identifying method of this embodiment, the operating mode of the charging/supplying system is determined, not only based on the detection value of the control signal representing the condition of fit of the connector that connects the vehicle with the first external device or second external device, but based on a combination of the detection value and at least one of the other detection values. Thus, according to the identifying method of this embodiment, the erroneous determination as described above is prevented, and the operating mode of the charging/supplying system can be determined with high reliability.

Also, in this embodiment, the operating mode of the charging/supplying system may be determined, based on the detection value of the control signal representing a connecting condition of the cable that connects the first external device with the vehicle, the feasibility of supplying electric power from the first external device to the vehicle, or the rated current of the first external device, which is detected in a signal channel provided between the vehicle and the first external device or second external device, and at least one of the other detection values.

The above-mentioned control signal is a signal for transmitting a connecting condition of the cable that connects the first external device with the vehicle, the feasibility of supplying electric power from the first external device to the vehicle, or the rated current of the first external device, for example, to the vehicle-side control means when the electric storage device installed on the vehicle is charged with electric power from the first external device. More specifically, the pulse width of the control signal may be modulated according to the connecting condition of the cable that connects the first external device with the vehicle, the feasibility of supplying electric power from the first external device to the vehicle, or the rated current of the first external device, for example. Also, the control signal may be detected as a voltage that varies according to the connecting condition of the cable that connects the first external device with the vehicle, the feasibility of electric power from the first external device to the vehicle, or the rated current of the first external device. Accordingly, detection of a control signal having a certain frequency or voltage means that the first external device is correctly connected to the vehicle.

As described above, when the control signal is correctly detected in the signal channel provided between the vehicle and the first external device or second external device, the first external device is correctly connected to the vehicle. Accordingly, if the operating mode of the charging/supplying system is erroneously set to the supplying mode, electrical short circuit may occur to the power conversion mechanism installed on the vehicle or the first external device, and various components or units that constitute the system that permits electric power to be transmitted between the vehicle and the exterior (thereof) may suffer from problems, such as (a) fault (failure), breakage, and burning. Accordingly, when the control signal is correctly detected in the signal path, the operating mode of the charging/supplying system should be set to the charging mode.

However, in some cases, the result of detection of the control signal in the signal channel may be based on erroneous detection due to some cause. In such cases, even if the operating mode of the charging/supplying system is set to the charging mode, only based on the result of detection, the first external device may not be actually connected to the vehicle, and charging of the electric storage device installed on the vehicle may not be performed.

On the other hand, if the control signal is not correctly detected in the signal channel, at least the first external device is not correctly connected to the vehicle. Accordingly, even if the operating mode of the charging/supplying system is erroneously set to the charging mode, the electric storage device installed on the vehicle is not correctly charged since the first external device is not correctly connected to the vehicle, and, depending on the circumstances, the electric storage device installed on the vehicle may suffer from a problem, such as failure, breakage, or burning. Accordingly, when the control signal is not correctly detected in the signal channel, it can be determined that the operating mode of the charging/supplying system should not be set to the charging mode. However, it cannot be specified or determined whether the operating mode of the charging/supplying system should be set to the supplying mode, only based on the result of detection.

The situation where the control signal is not correctly detected in the signal channel may be based on erroneous detection due to some cause. In this case, if the operating mode of the charging/supplying system is not set to the charging mode, only based on the above situation, but it is not determined whether the operating mode of the charging/supplying system should be set to the supplying mode, charging of the electric storage device installed on the vehicle with electric power from the first external device or supplying of electric power from the vehicle to the second external device may not be performed though it should have been done as originally intended.

However, according to the identifying method of this embodiment, the operating mode of the charging/supplying system is determined, based on the detection value of the control signal representing the connecting condition of the cable that connects the first external device with the vehicle, the feasibility of supplying electric power from the first external device to the vehicle, or the rated current of the first external device, which is detected in the signal channel provided between the vehicle and the first external device or second external device, and at least one of the other detection values. Accordingly, according to the identifying method of this embodiment, the erroneous determination as described above is prevented, and the operating mode of the charging/supplying system can be determined with high reliability.

As mentioned above, as one of the standards for electric vehicles having on-board batteries that can be charged with electric power fed from houses, "SAE Electric Vehicle Conductive Charge Coupler" ("SAE Electric Vehicle Conductive Charge Coupler" (US), SAE Standards, SAE international, Nov. 2001) is established by the Society of Automotive Engineers (SAE) in the U.S. The SAE (the Society of Automotive Engineers) is a group of automotive engineers in the U.S. Most of charging systems for charging electric storage devices installed on plug-in hybrid vehicles (PHV), electric vehicles (EV), and the like, which are widely prevailing in these days, comply with the standards established by the SAE.

Among various standards established by the SAE, the J1772 standard is established as a standard concerning various control signals, cable, connector, etc. in a charging system for charging an electric storage device installed on the vehicle with electric power from a first external device. The various control signals include, for example, a cable connection signal (or proximity detection signal) for transmitting information used for determining a condition of fit between the charging connector and the connecting portion (inlet), based on change in the impedance of the signal channel, a CPLT signal (pilot signal) for transmitting information, such as a connecting condition of the charging cable, the feasibility of supplying electric power from the power supply to the vehicle, the rated current of the EVSE, etc. to the vehicle-side control circuit.

The cable connection signal, as one of the above various control signals, is detected as a change in the impedance of the signal channel corresponding to a condition of fit between the charging connector and the connecting portion (inlet), by the detecting means provided in the charging system for charging the electric storage device installed on the vehicle with electric power from the first external device, for example, and the condition of fit between the connector and the connecting portion is determined by the control device provided in the charging system, based on the detection value. Accordingly, the cable connection signal corresponds to the control signal representing a condition of fit of the connector that connects the vehicle with the first external device or second external device, in the second embodiment of the invention.

Also, the CPLT signal, as one of the above various control signals, is a control signal that is subjected to pulse-width modulation or voltage adjustment according to the connecting condition of the cable for connecting the first external device with the vehicle, the feasibility of supplying electric power from the first external device to the vehicle, or the rated current of the first external device, for example. Accordingly, the CPLT signal corresponds to the control signal representing the connecting condition of the cable for connecting the first external device with the vehicle, the feasibility of supplying electric power from the first external device to the vehicle, or the rated current of the first external device, in the second embodiment of the invention.

Accordingly, in the method for identifying the operating mode of the charging/supplying system according to the invention, the plurality of detection values used as criteria based on which the operating mode of the charging/supplying system is determined may include one or both of the cable connection signal and the CPLT signal.

Accordingly, an identifying method according to a third embodiment of the invention is provided by adding the feature that the control signal representing the condition of fit of the connector is the cable connection signal (proximity detection signal), to the identifying method according to the second embodiment of the invention.

Also, an identifying method according to a fourth embodiment of the invention is provided by adding the feature that the control signal representing the connecting condition of the cable for connecting the first external device with the vehicle, the feasibility of supplying electric power from the first external device to the vehicle, or the rated current of the first external device is the CPLT signal (pilot signal), to the identifying method according to the second embodiment of the invention.

Further, an identifying method according to a fifth embodiment of the invention is provided by adding the feature that the control signal representing the condition of fit of the connector is the cable connection signal, and that the control signal representing the connecting condition of the cable for connecting the first external device with the vehicle, the feasibility of supplying electric power from the first external device to the vehicle, or the rated current of the first external device is the CPLT signal, to the identifying method according to the second embodiment of the invention.

As described above, in the identifying method according to this embodiment, the operating mode of the charging/supplying system is determined based on a plurality of detection values including a detection value of one of the cable connection signal and the CPLT signal or detection values of both of the cable connection signal and the CPLT signal. Accordingly, the identifying method of this embodiment can be easily applied to the charging system for charging the electric storage device installed on a vehicle, such as a plug-in hybrid vehicle (PHV) or an electric vehicle (EV), which is widely prevailing in these days and is compliant with the SAE standards. Namely, the identifying method of this embodiment makes it possible to easily realize a charging/supplying system capable of identifying the operating mode with reliability, without significantly changing the configuration of the charging system that is widely prevailing in these days and is compliant with the SAE standards. Thus, the above feature of the identifying method according to this embodiment is considerably useful in identifying the charging mode or the supplying mode as the operating mode, without substantially suffering from inconveniences, such as increases in the size, complexity, and cost of the system.

As described above, in the identifying method for identifying the operating mode of the charging/supplying system in which the vehicle is connected with the first external device or the second external device via the connecting portion used in common in the charging mode in which the electric storage device installed on the vehicle is charged with electric power from the first external device and the supplying mode in which electric power is supplied from the vehicle to the second external device, the charging/supplying system being operable in a selected one of the charging mode and the supplying mode, a plurality of detection values are detected from at least one electric connection channel provided between the vehicle and the first external device or the second external device via the connecting portion, and it can be determined whether the operating mode of the charging/supplying system is the charging mode or the supplying mode, based on a combination of the plurality of detection values. As the combination of the detection values, a combination of one or more of various detection values as described above, and a detection value(s) suitably selected from various detection values other than the above-described values may be used.

Accordingly, an identifying method according to a sixth embodiment of the invention is provided by adding the feature that the plurality of detection values include the detection value corresponding to the presence or absence of a voltage applied from the first external device to the vehicle, the detection value of the cable connection signal, and the detection value of the CPLT signal, to the identifying method according to the fifth embodiment of the invention.

As described above, in the identifying method of this embodiment, the detection value corresponding to the presence or absence of the PLC communication detected in the electric power channel provided between the vehicle and the first external device or the second external device, and the detection value of a signal transmitted by the PLC communication are not necessarily included in the plurality of detection values. Accordingly, the identifying method of this embodiment is useful when it is determined whether the operating mode of a charging/supplying system that is not equipped with a mechanism for PLC communication is the charging mode or the supplying mode.

On the other hand, when it is determined whether the operating mode of a charging/supplying system equipped with a mechanism for PLC communication is the charging mode or the supplying mode, the detection value corresponding to the presence or absence of the PLC communication detected in the electric power channel provided between the vehicle and the first external device or the second external device and the detection value of the signal transmitted by the PLC communication are preferably included in the plurality of detection values.

Accordingly, an identifying method according to a seventh embodiment of the invention is provided by adding the feature that the plurality of detection values include the detection value corresponding to the presence or absence of a voltage applied from the first external device to the vehicle, the detection value corresponding to the presence or absence of the PLC communication, the detection value of the signal transmitted by the PLC communication, the detection value of the cable connection signal, and the detection value of the CPLT signal, to the identifying method according to the fifth embodiment of the invention.

As described above, the operating mode of the charging/supplying system corresponding to each of various combinations of the detection values may be determined as appropriate, in view of the construction or configuration and conditions of use of the vehicle, a first external device, a second external device and the charging/supplying system, and the severity of a problem that is presumed to happen when the operating mode of the charging/supplying system is erroneously determined due to erroneous detection of one or more of the individual detection values, for example. In this connection, a correspondence relationship between each of the combinations of the plurality of detection values and the operating mode of the charging/supplying system may be determined in advance, and the operating mode of the charging/supplying system may be determined based on the predetermined correspondence relationship when the identifying method according to each of the above embodiments is carried out.

Namely, an identifying method according to an eighth embodiment of the invention is provided by adding the feature that the correspondence relationship between the combination of the plurality of detection values and the operating mode of the charging/supplying system is determined in advance, and it is determined, based on the correspondence relationship, whether the operating mode of the charging/supplying system is the charging mode or the supplying mode, to the identifying method according to any one of the first through seventh embodiments of the invention.

In this embodiment, the correspondence relationship between the combination of the plurality of detection values and the operating mode of the charging/supplying system may be determined in advance, in view of the construction or configuration and conditions of use of the vehicle, a first external device, a second external device and the charging/supplying system, and the severity of a problem presumed to happen when the operating mode of the charging/supplying system is erroneously determined due to erroneous detection of one or more of the detection values, for example.

As a specific method for determining whether the operating mode of the charging/supplying system is the charging mode or the supplying mode, based on the correspondence relationship, a program in which various commands for causing the CPU provided in the control means of the charging/supplying system to execute a process of controlling the charging/supplying system so that the charging/supplying system operates in the operating mode corresponding to each of the combinations of the plurality of detection values are described is stored in a data storage device provided in the control means, and the CPU performs various operations according to the program.

In another example, the correspondence relationship between each of the combinations of the plurality of detection values and the operating mode of the charging/supplying system may be stored as a data table in a data storage device provided in the control means of the charging/supplying system, and the control means of the charging/supplying system may be configured so that the CPU provided in the control means of the charging/supplying system can specify or determine the operating mode corresponding to each of the combinations of the plurality of detection values, with reference to the data table, when executing a process of identifying the operating mode of the charging/supplying system. It is, however, to be understood that the above description is merely exemplary, and that the specific procedure of carrying out the method of identifying the operating mode of the charging/supplying system based on the predetermined correspondence relationship between each combination of the plurality of detection values and the operating mode of the charging/supplying system, and the configuration of the control means of the charging/supplying system are not limited to the above description.

As described above, in the identifying method according to each of the illustrated embodiment of the invention, it is not determined only based on a particular control signal whether the charging/supplying system operates in the charging mode or the supplying mode, but is determined based on a combination of a plurality of detection values detected from at least one electric connection channel provided between the vehicle and an external device. In this manner, according to the identifying method of each of the embodiments, it is determined with high reliability whether the operating mode of the system that permits electric power to be transmitted between the vehicle and the exterior thereof is the charging mode or the supplying mode.

As described above in the initial part of the specification, the present invention also relates to an identifying system that identifies an operating mode of a charging/supplying system that is operable in a selected one of a charging mode in which an electric storage device installed on the vehicle is charged with electric power from a first external device and a supplying mode in which electric power is supplied from the vehicle to a second external device, when a common connecting portion is used in the charging mode and the supplying mode. The configuration of the identifying system according to the invention and various operations performed by the identifying system are obvious to those skilled in the art, from the above description concerning the identifying method according to each embodiment of the invention.

Thus, while some of various embodiments of the identifying system according to the invention will be listed below, details of the identifying system according to each of the embodiments will not be described.

A ninth embodiment of the invention is in the form of an identifying system that identifies an operating mode of a charging/supplying system in which a vehicle is connected with a first external device or a second external device via a connecting portion used in common in a charging mode in which an electric storage device installed on the vehicle is charged with electric power from the first external device and a supplying mode in which electric power is supplied from the vehicle to the second external device, the charging/supplying system being operable in a selected one of the charging mode and the supplying mode. The identifying system is characterized in that a plurality of detection values are detected from at least one electric connection channel provided between the vehicle and the first external device or the second external device via the connecting portion, and that it is determined whether the operating mode of the charging/supplying system is the charging mode or the supplying mode, based on a combination of the above-indicated plurality of detection values.

A tenth embodiment of the invention is the identifying system according to the ninth embodiment of the invention, which is further characterized in that the plurality of detection values include at least one detection value selected from a detection value corresponding to the presence or absence of a voltage applied from the first external device to the vehicle, which is detected in the electric power channel provided between the vehicle and the first external device or the second external device, a detection value corresponding to the presence or absence of PLC communication detected in the electric power channel provided between the vehicle and the first external device or the second external device and a detection value of a signal transmitted by the PLC communication, a detection value of a control signal representing a condition of fit of a connector that connects the vehicle with the first external device or the second external device, which is detected in a signal path provided between the vehicle and the first external device or the second external device, and a detection value of a control signal representing a connecting condition of a cable that connects the first external device with the vehicle, the feasibility of supplying electric power from the first external device to the vehicle, or the rated current of the first external device, which is detected in a signal channel provided between the vehicle and the first external device or the second external device.

An identifying system according to an eleventh embodiment of the invention is provided by adding the feature that the control signal representing the condition of fit of the connector is the cable connection signal, to the identifying system according to the tenth embodiment of the invention.

An identifying system according to a twelfth embodiment of the invention is provided by adding the feature that the control signal representing the connecting condition of the cable for connecting the first external device with the vehicle, the feasibility of supplying electric power from the first external device to the vehicle, or the rated current of the first external device is the CPLT signal, to the identifying system according to the tenth embodiment of the invention.

An identifying system according to a thirteenth embodiment of the invention is provided by adding the feature that the control signal representing the condition of fit of the connector is the cable connection signal, and the control signal representing the connecting condition of the cable for connecting the first external device with the vehicle, the feasibility of supplying electric power from the first external device to the vehicle, or the rated current of the first external device is the CPLT signal, to the identifying system according to the tenth embodiment of the invention.

An identifying system according to a fourteenth embodiment of the invention is provided by adding the feature that the plurality of detection values include the detection value corresponding to the presence or absence of a voltage applied from the first external device to the vehicle, the detection value of the cable connection signal, and the detection value of the CPLT signal, to the identifying system according to the thirteenth embodiment of the invention.

An identifying system according to a fifteenth embodiment of the invention is provided by adding the feature that the plurality of detection values include the detection value corresponding to the presence or absence of a voltage applied from the first external device to the vehicle, the detection value corresponding to the presence or absence of the PLC communication, the detection value of the signal transmitted by the PLC communication, the detection value of the cable connection signal, and the detection value of the CPLT signal, to the identifying system according to the thirteenth embodiment of the invention.

An identifying system according to a sixteenth embodiment of the invention is provided by adding the feature that the correspondence relationship between the combination of the plurality of detection values and the operating mode of the charging/supplying system is determined in advance, and it is determined, based on the correspondence relationship, whether the operating mode of the charging/supplying system is the charging mode or the supplying mode, to the identifying system according to any one of the ninth through fifteenth embodiments of the invention.

As described above, in the identifying method and identifying system according to each embodiment of the invention, it is not determined only based on a particular control signal whether the operating mode of the charging/supplying system is the charging mode or the supplying mode, but the determination is made based on a combination of two or more detection values detected from at least one electric connection channel provided between the vehicle and an external device. In this manner, according to the identifying method and identifying system of each embodiment of the invention, it can be determined with reliability whether the operating mode of the system that permits electric power to be transmitted between the vehicle and the exterior thereof is the charging mode or the supplying mode.

In the following, a particular embodiment of the invention will be described with reference to the accompanying drawings. It is, however, to be understood that the following description is merely exemplary, and the scope of the invention should not be construed as being limited to the following description.

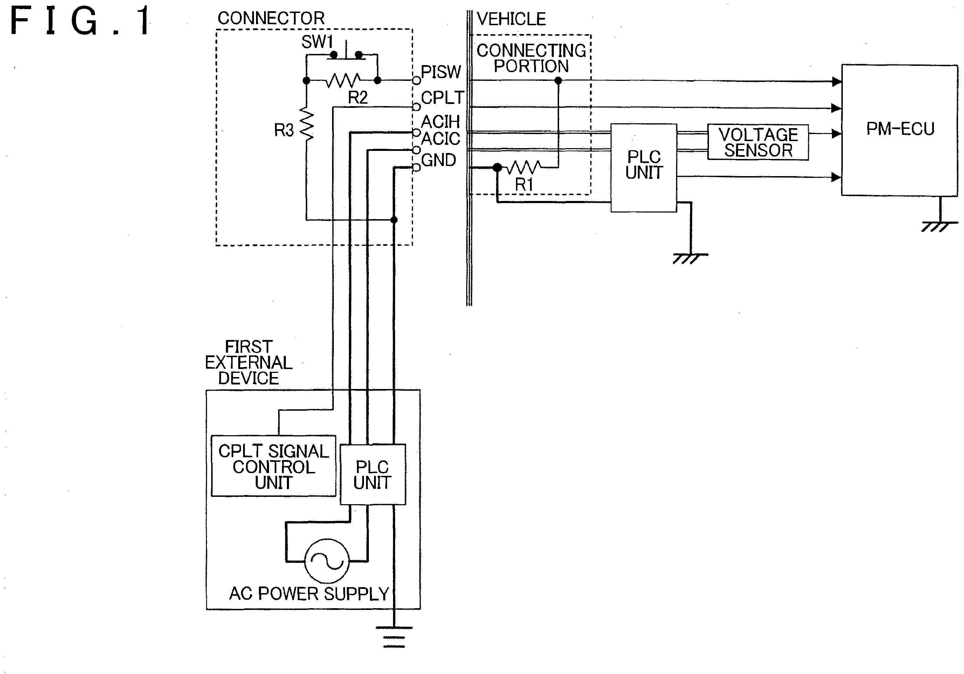

Initially, the configuration or arrangement of an identifying system according to one embodiment of the invention will be described. As described above, FIG. 1 is a schematic view useful for explaining the configuration of the identifying system according to one embodiment of the invention. In this embodiment, the operating mode of the charging/supplying system is identified based on a combination of a detection value corresponding to the presence or absence of a voltage applied from the first external device to the vehicle in an electric power channel, a detection value corresponding to the presence or absence of PLC communication via the electric power channel and a detection value of a signal transmitted by the PLC communication, a detection value of a cable connection signal in a cable connection signal channel, and a detection value of a CPLT signal in a CPLT signal channel, as one example for explaining the invention.

In FIG. 1, the vehicle, the first external device, and a connector electrically connected to the first external device are illustrated. The vehicle includes a connecting portion to which the connector is fitted so that the vehicle and the first external device are electrically connected to each other, various detecting means for detecting electric power and various signals, etc. supplied to the vehicle via the connecting portion, and a power control device PM-ECU that performs electric power control in the vehicle based on detection values detected by the respective detecting means. The power control device PM-ECU may be configured as an electronic control unit including, for example, CPU, data storage device(s), and data input/output ports (any of which is not shown).

The first external device includes an AC power supply, a CPLT signal control unit that generates a CPLT signal as a control signal representing a connecting condition of a cable that connects the first external device with the vehicle, the feasibility of supplying electric power from the first external device to the vehicle, or the rated current of the first external device, and a PLC unit that conducts PLC communications for transmitting a control signal as a command to operate the system in the charging mode or the supplying mode from the AC power supply to the vehicle, while carrying the signal on the electric power channel through which electric power is supplied.

The connector includes a cable connection signal channel that transmits the cable connection signal corresponding to the condition of fit between the connecting portion provided in the vehicle and the connector, a CPLT signal channel that transmits the CPLT signal generated by the CPLT signal control unit provided in the first external device, an electric power channel that transmits electric power supplied from the AC power supply provided in the first external device, and the ground. The connector also includes terminals for electrically connecting these electric connection channels with corresponding electric connection channels of the connecting portion when the connector is fitted to the connecting portion. More specifically, these terminals are PISW corresponding to the cable connection signal channel, CPLT corresponding to the CPLT signal channel, ACIH (hot side) and ACIC (cold side) corresponding to the electric power channel, and GND corresponding to the ground.

The cable connection signal is detected as a combined resistance value of the cable connection signal channel, which value changes in accordance with a condition of fit between the connecting portion provided in the vehicle and the connector. In this embodiment, a switch SW1 disposed in parallel with a resistor R2 in the connector is arranged to be opened and closed in accordance with the condition of fit between the connector and the connecting portion, so as to change the combined resistance value of the cable connection signal channel, using a microswitch, or the like, which operates in conjunction with an operation to fit a protrusion of a lock mechanism (not shown) provided in the connector in a corresponding recess of the connecting portion.

More specifically, the switch SW1 is arranged to be closed in a non-fit condition in which the connector and the connecting portion have not been fitted with each other (and thus the signal channel provided in the connector is not electrically connected with the signal channel provided in the connecting portion). Also, the switch SW1 is arranged to be opened in a half-fit condition in which the connector and the connecting portion are not completely fitted with each other though the cable connection signal channel provided in the connector is electrically connected with the cable connection signal channel provided in the connecting portion. Further, the switch SW1 is arranged to be closed again in a complete-fit condition in which the connector and the connecting portion are completely fitted with each other, and the cable connection signal channel provided in the connector is electrically connected with the cable connection signal channel provided in the connecting portion.

In the non-fit condition in which the connector and the connecting portion are not electrically connected to each other, the value of combined impedance (combined resistance value) between the cable connection signal channel and the ground, which is detected by the vehicle-side detecting means, is equal to the resistance value of a resistor R1 placed between the cable connection signal channel of the connecting portion provided in the vehicle and the ground. In the half-fit condition in which the connector and the connecting portion are electrically connected with each other but the switch SW1 is opened, the combined resistance value is equal to a combined resistance value of the resistor R1 in the connecting portion and the resistors R2 and R3 in the connector. In the complete-fit condition in which the connector and the connecting portion are electrically connected to each other and the switch SW1 is closed, the combined resistance value is equal to a combined resistance value of the resistor R1 in the connecting portion and the resistor R3 in the connector. In this case, the resistor R2 provided in the connector is bypassed by the switch SW1, and thus does not contribute to the combined resistance value.

When the second external device, in place of the first external device as shown in FIG. 1, is connected to the vehicle, so as to permit electric power to be supplied from the vehicle to the second external device, the resistance value of the resistor R3 placed on the cable connection signal channel of the connector electrically connected to the second external device is set to a value (e.g., a lower resistance value) different from that of the connector shown in FIG. 1, so that the connector fitted to the connecting portion provided in the vehicle can be identified as a connector (i.e., supplying connector) for the second external device. Thus, the power control device PM-ECU can determine whether the operating mode is the charging mode or the supplying mode, based on the combined resistance value between the cable connection signal channel and the ground.

As described above, the CPLT signal is a control signal representing information, such as a connecting condition of a cable that connects the first external device with the vehicle, the feasibility of supplying electric power from the first external device to the vehicle, or the rated current of the first external device, and the CPLT signal control unit modulates the pulse width of the CPLT signal so as to provide a given frequency and/or voltage commensurate with the information. Namely, when the CPLT signal having a given frequency and/or voltage is detected, it means that the first external device is connected to the vehicle. When the CPLT signal is not detected, it means that the first external device is not connected to the vehicle. Thus, the feasibility of operating the system in the charging mode can also be determined based on the CPLT signal.

Further, in the PLC communications via the electric power channel, a control signal as a command to operate the charging/supplying system in the charging mode or the supplying mode is transmitted to the power control device PM-ECU. When the first external device is connected to the vehicle, in addition to the transmission of the control signal, electric power supplied from the AC power supply provided in the first external device is transmitted (supplied) to the vehicle via the electric power channel. Namely, detection of electric power supplied from the AC power supply of the first external device in the electric power channel means that the first external device is connected to the vehicle. Accordingly, in this case, electric power should not be supplied from the vehicle side. Thus, the power control device PM-ECU can also determine the feasibility of operating the system in the supplying mode, based on the detection value in the electric power channel.

In this embodiment, it is determined whether the operating mode of the charging/supplying system is the charging mode or the supplying mode, based on a combination of the cable connection signal, CPLT signal, control signal transmitted by the PLC communication, and the presence or absence of electric power supplied in the electric power channel. Thus, the operating mode of the charging/supplying system is identified based on a combination of the plurality of detection values, so that the operating mode of the charging/supplying system can be controlled with higher reliability, than the identifying method of the related art in which the operating mode is identified only based on a particular control signal.

Next, the correspondence relationship between the combination of the plurality of detection values and the operating mode of the charging/supplying system will be described. In the identifying system of this embodiment having the arrangement as shown in FIG. 1, the operating mode of the charging/supplying system corresponding to each combination of the plurality of detection values is determined in advance as indicated in TABLE 1 below, and the correspondence relationship is stored in the form of a data table in the data storage device provided in the power control device PM-ECU. When the CPU provided in the power control device PM-ECU executes the process of identifying the operating mode of the charging/supplying system, the CPU specifies the operating mode corresponding to each combination of the plurality of detection values, in the manner as will be described below.

**TABLE 1**

| Condition 1 | Condition 2 | Condition 3 | Condition 4 | Operating Mode |
|---|---|---|---|---|
| PISW | CPLT | PLC | Electric Power | |
| Charging | Signal Detected | Charging Permitted | Detected | Charging |
| | | | Not Detected | Charging |
| | | Supplying Requested | Detected | Charging |
| | | | Not Detected | Power Stop |
| | | No Signal | Detected | Charging |
| | | | Not Detected | Charging |
| | No Signal | Charging Permitted | Detected | Charging |
| | | | Not Detected | Charging |
| | | Supplying Requested | Detected | Power Stop |
| | | | Not Detected | Power Stop |
| | | No Signal | Detected | Charging |
| | | | Not Detected | Power Stop |
| Supplying | Signal Detected | Charging Permitted | Detected | Charging |
| | | | Not Detected | Charging |
| | | Supplying Requested | Detected | Power Stop |
| | | | Not Detected | Power Stop |
| | | No Signal | Detected | Power Stop |
| | | | Not Detected | Power Stop |
| | No Signal | Charging Permitted | Detected | Charging |
| | | | Not Detected | Power Stop |
| | | Supplying Requested | Detected | Power Stop |
| | | | Not Detected | Supplying |
| | | No Signal | Detected | Power Stop |
| | | | Not Detected | Supplying |

As indicated above in TABLE 1, it is determined, as Condition 1, whether the supplying/charging system should operate in the supplying mode or the charging mode, based on the value of impedance (combined resistance value) of the cable connection signal channel, as described above. Also, as Condition 2, the operating mode of the supplying/charging system is determined, based on the presence or absence of the CPLT signal transmitted via the CPLT signal channel from the known first external device, as described above. Further, as Condition 3, the operating mode of the supplying/charging system is determined, based on the presence or absence of a signal transmitted or received via the electric power channel by PLC communication and the content of the signal transmitted by the PLC communication. Furthermore, the operating mode of the supplying/charging system is determined, based on the presence or absence of electric power supplied via the electric power channel.

As described above, in the identifying method according to this embodiment, it is determined whether the operating mode of the charging/supplying system is the charging mode or the supplying mode, based on a combination of the plurality of detection values used as Conditions 1 through 4. In some cases, it is desirable that neither the charging mode nor the supplying mode is established or carried out; therefore, the power stop mode is provided as a third operating mode that is not the charging mode nor the supplying mode.

For example, when the charging mode is determined based on all of the cable connection signal as Condition 1, the CPLT signal as Condition 2, and the PLC signal as Condition 3, and electric power supplied via the electric power channel as Condition 4 is also detected, as indicated in the first line in TABLE 1, the charging mode is determined with high reliability as the operating mode of the supplying/charging system. To the contrary, when the supplying mode is determined based on all of the cable connection signal as Condition1, the CPLT signal as Condition 2, and the PLC signal as Condition 3, and electric power supplied via the electric power channel as Condition 4 is not detected, as indicated in the third line from the bottom in TABLE 1, the supplying mode is determined with high reliability as the operating mode of the supplying/charging system.

On the other hand, when consistent detection results cannot be obtained from the plurality of detection values as described above, the operating mode of the charging/ supplying system corresponding to each combination of the plurality of detection values may be determined as appropriate, in view of the result of determination based on each of the detection values, the severity of a problem that is presumed to happen in the event that each of the detection values is erroneously obtained, the construction or configuration and conditions of use of the vehicle, a first external device, a second external device, and the charging/supplying system, and so forth.

For example, when electric power supplied via the electric power channel as Condition 4 is detected even though the supplying mode is determined based on all of the cable connection signal as Condition 1, the CPLT signal as Condition 2, and the PLC signal as Condition 3, as indicated in the fourth line from the bottom in TABLE 1, the probability that electric power is being supplied from the first external device to the vehicle is determined as being considerably high. Accordingly, in this case, if the operating mode of the supplying/charging system is determined as the supplying mode based on the results associated with Conditions 1 through 3, and electric power starts being supplied from the vehicle to an external device, electrical short circuit, or the like, may occur between the vehicle and the first external device, and the first external device, and the electric storage device and power generating device installed on the vehicle may suffer from problems, such as breakage and burning. In the identifying method of this embodiment, the supplying/charging system is arranged not to supply electric power from the vehicle to the external device, in view of the above concern, when electric power supplied via the electric power channel as Condition 4 is detected, as shown in TABLE 1.

As described above, in the identifying method of this embodiment, the determination as to whether the operating mode is the charging mode or the supplying mode is not made only based on one detection value, such as a particular control signal, but is made based on a combination of a plurality of detection values detected from at least one electric connection channel provided between the vehicle and the first external device or second external device. In this manner, a risk of erroneously determining the operating mode of the charging/supplying system can be reduced, even when the particular control signal, or the like, is not correctly detected for some reason, such as breakage of the signal channel that transmits the control signal, a failure or malfunction of a detecting means for detecting the control signal, or increase of contact resistance due to poor contact between the connecting portion (e.g., an inlet) and the connector, or age-related deterioration, for example.

As described above, if the operating mode is erroneously determined, problems, such as a failure to charge the electric storage device installed on the vehicle with electric power from the first external device, or a failure to supply electric power from the vehicle to the second external device, may occur. In other cases, charging of the electric storage device installed on the vehicle using the first external device and supplying of electric power from the vehicle to the second external device may be carried out at the same time, which may result in electrical short circuit between the vehicle and the first external device, and thus incur situations, such as breakage, burning, etc. of the first external device and the electric storage device and power generating device installed on the vehicle. However, according to the identifying method of this embodiment, it is possible to reliably determine whether the operating mode of the system that permits electric power to be transmitted between the vehicle and the exterior thereof is the charging mode or the supplying mode; therefore, the above-described problems are less likely to occur or prevented from occurring.

The correspondence relationship between each of the various combinations of the plurality of detection values and the operating mode of the charging/supplying system as indicated in TABLE 1 is to be considered merely as one example. Namely, as described above, the operating mode of the charging/supplying system corresponding to each of various combinations of the plurality of detection values may be determined as appropriate, in view of the construction or configuration and conditions of use of the vehicle, a first external device, a second external device, and the charging/supplying system, and the severity of a problem presumed to happen when the operating mode of the charging/supplying system is erroneously determined due to erroneous detection of any of the detection values, for example.

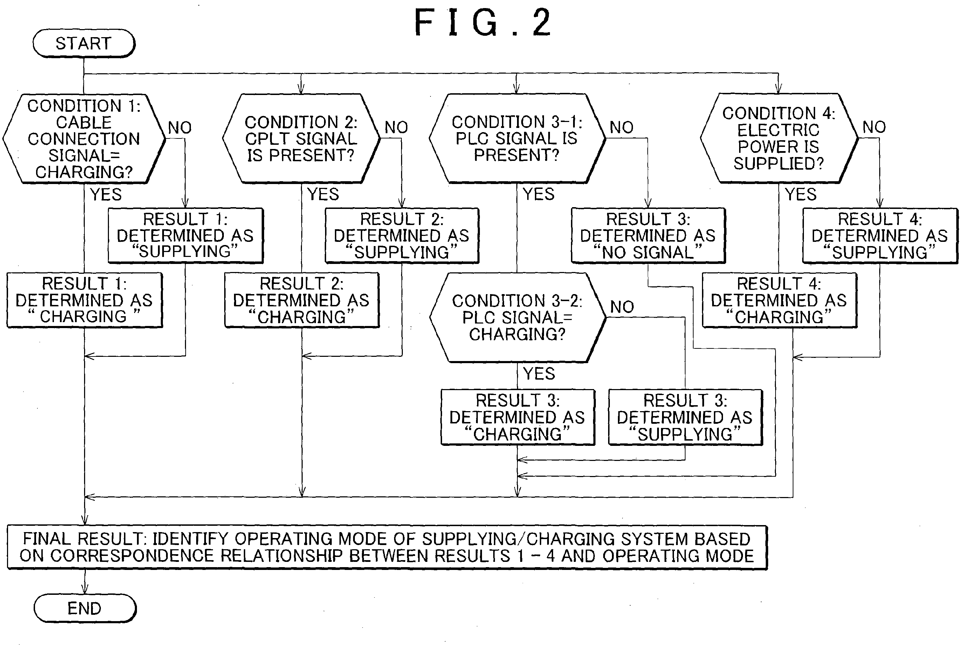

Next, the procedure of executing the method for identifying the operating mode of the charging/supplying system will be described. Here, one example of the method for identifying the operating mode of the charging/supplying system will be described with reference to FIG. 2. FIG. 2 is a flowchart illustrating the flow of various operations performed in the identifying method according to one embodiment of the invention. In this embodiment, the operating mode of the charging/supplying system is identified using the combinations of the detection values as indicated in TABLE 1 above.

In the flowchart as shown in FIG. 2, the value of impedance (combined resistance value) of the cable connection signal channel, the presence or absence of the CPLT signal, the presence or absence of PLC communication and the content of the signal transmitted by the PLC communication, and the presence or absence of electric power supplied via the electric power channel, which correspond to Conditions 1 through 4, respectively, are detected or determined by various detecting means provided in the power control device PM-ECU installed on the vehicle, for example, and results of determination corresponding to Conditions 1 through 4 are obtained or specified as Results 1 through 4, respectively. It is to be understood that the order of making determinations based on Conditions 1 through 4 is not particularly limited, as shown in the flowchart of FIG. 2, but may be determined as appropriate, in view of the construction or configuration and conditions of use of the vehicle, a first external device, a second external device, and the charging/supplying system.

Then, Results 1 through 4 specified as described above are checked against the correspondence relationship between each combination of the plurality of detection values and the operating mode of the charging/supplying system as indicated in TABLE 1 above, and the operating mode of the charging/supplying system matching the combination of the specified Results 1 through 4 is specified or determined. Thus, the final determination result regarding the operating mode of the charging/supplying system is obtained.

In the identifying method according to this embodiment, a plurality of detection values corresponding to the voltage or current of electric power supplied via the electric power channel, various control signals transmitted via the signal channels, etc. are obtained or detected by detecting means (e.g., various sensors, such as a voltage sensor) provided in at least one electric connection channel provided between the vehicle and the first external device or second external device, and the power control device PM-ECU including CPU, data storage device, data input/output ports, etc. determines whether the operating mode of the charging/supplying system is the charging mode or the supplying mode, based on a combination of the above-indicated plurality of detection values, thereby to obtain results of determination corresponding to Conditions 1 through 4, respectively, as described above.

The various operations to determine whether the operating mode of the charging/supplying system is the charging mode or the supplying mode as illustrated in the flowchart of FIG. 2 are stored in the data storage device, as a program for causing the CPU to perform these operations. Further, the correspondence relationship between each combination of the plurality of detection values and the operating mode of the charging/supplying system as indicated in TABLE 1 above is stored as a data table in the data storage device provided in the control means of the charging/supplying system. When the CPU provided in the control means of the charging/supplying system executes the process of identifying the operating mode of the charging/supplying system according to the above-described program, the CPU can specify the operating mode corresponding to each combination of the plurality of detection values, with reference to the above-mentioned data table.

As described above, according to the identifying method of this embodiment, the operating mode of the charging/supplying system is not determined only based on one detection value, such as a particular control signal, but the operating mode of the charging/supplying system is determined based on a combination of a plurality of detection values detected from at least one electric connection channel provided between the vehicle and the first external device or second external device. In this manner, a risk of erroneously determining the operating mode of the charging/supplying system can be reduced, even when the particular control signal, or the like, is not correctly detected for some reason, such as breakage of the signal channel that transmits the control signal, a failure or malfunction of the detecting means for detecting the control signal, or increase of contact resistance due to poor contact between the connecting portion (e.g., an inlet) and the connector, or age-related deterioration, for example.

While some embodiments having particular arrangements have been described above in order to explain the present invention, the above description is merely exemplary, and the embodiments of the invention should not be construed as being limited to the above description. Needless to say, the scope of the invention is not limited to the exemplary embodiments as described above, but the embodiments may be modified as needed, without departing from the scope of the invention as defined by the appended claims.

## Claims

1. An identifying method for identifying an operating mode of a charging/supplying system, comprising:
detecting a plurality of detection values from at least one electric connection channel provided between a vehicle and a first external device or provided between the vehicle and a second external device via a connecting portion, in the charging/supplying system in which the vehicle is connected with the first external device or the second external device via the connecting portion used in common in a charging mode and a supplying mode, the charging mode being a mode in which an electric storage device installed on the vehicle is charged with electric power from the first external device to the electric storage device, the supplying mode being a mode in which electric power is supplied from the vehicle to the second external device, the charging/supplying system being configured to be operated in a selected one of the charging mode and the supplying mode; and
determining whether the operating mode of the charging/supplying system is the charging mode or the supplying mode, based on a correspondence relationship between the plurality of detection values and the operating mode of the charging/supplying system, wherein the plurality of detection values include at least two detection values selected from:
a detection value corresponding to the presence or absence of a voltage applied from the first external device to the vehicle, the detection value being detected in an electric power channel provided between the vehicle and the first external device or provided between the vehicle and the second external device;
a detection value corresponding to the presence or absence of PLC communication detected in the electric power channel provided between the vehicle and the first external device or provided between the vehicle and the second external device;
a detection value of a signal transmitted by the PLC communication detected in the electric power channel provided between the vehicle and the first external device or provided between the vehicle and the second external device;
a detection value of a control signal representing a condition of fit of a connector that connects the vehicle with the first external device or the second external device, the detection value being detected in a signal channel provided between the vehicle and the first external device or provided between the vehicle and the second external device;
a detection value of a control signal representing a connecting condition of a cable that connects the first external device with the vehicle, the detection value being detected in the signal channel provided between the vehicle and the first external device or provided between the vehicle and the second external device;
a detection value of a control signal representing a feasibility of supplying electric power from the first external device to the vehicle, the detection value being detected in the signal channel provided between the vehicle and the first external device or provided between the vehicle and the second external device; and
a detection value of a control signal representing a rated current of the first external device, the detection value being detected in the signal channel provided between the vehicle and the first external device or provided between the vehicle and the second external device wherein the operating mode includes a third operating mode, which is not the charging mode nor the supplying mode **characterized in that** the third operating mode is a power stop mode in which neither the charging mode nor the supplying mode is implemented wherein the identifying method further comprises the step of determining that the operating mode of the charging/ supplying system is a power stop mode when the voltage applied from the first external device to the vehicle is not detected.

2. The identifying method according to claim 1, wherein
the control signal representing the condition of fit of the connector is a cable connection signal which is compliant with a J1772 standard established by the SAE; and/or
the control signal representing the connecting condition of the cable that connects the first external device with the vehicle, the feasibility of supplying electric power from the first external device to the vehicle, or the rated current of the first external device is a CPLT signal.

3. The identifying method according to claim 2, wherein the plurality of detection values include the detection value corresponding to the presence or absence of the voltage applied from the first external device to the vehicle, a detection value of the cable connection signal which is compliant with a J1772 standard established by the SAE, and a detection value of the CPLT signal.

4. The identifying method according to claim 2, wherein the plurality of detection values include the detection value corresponding to the presence or absence of the voltage applied from the first external device to the vehicle, the detection value corresponding to the presence or absence of the PLC communication, the detection value of the signal transmitted by the PLC communication, a detection value of the cable connection signal which is compliant with a J1772 standard established by the SAE, and a detection value of the CPLT signal.

5. The identifying method according to claim 1, wherein the correspondence relationship is a relationship between each of the various combinations of the plurality of detection values and the operating mode of the charging/supplying system, which are determined in advance and stored in a data storage device.

6. The identifying method according to one of the claims 1 to 5, wherein one of the detection values is an impedance of the cable connection signal channel.

7. An identifying system for identifying an operation mode of a charging/supplying system, the identifying system comprising:
a connector configured to connect a vehicle with a first external device or a second external device via a connecting portion used in common in a charging mode and a supplying mode, the charging mode being a mode in which an electric storage device installed on the vehicle is charged with electric power from the first external device to the electric storage device and the supplying mode being a mode in which electric power is supplied from the vehicle to the second external device;
a detector configured to detect a plurality of detection values from at least one electric connection channel provided between the vehicle and the first external device or provided between the vehicle and the second external device via the connecting portion; and
an identifying device configured to determine whether the operating mode of the charging/supplying system is the charging mode or the supplying mode, based on a correspondence relationship between the plurality of detection values and the operating mode of the charging/supplying system, wherein the plurality of detection values include at least two detection values selected from:
a detection value corresponding to the presence or absence of a voltage applied from the first external device to the vehicle, the detection value being detected in an electric power channel provided between the vehicle and the first external device or provided between the vehicle and the second external device;
a detection value corresponding to the presence or absence of PLC communication detected in the electric power channel provided between the vehicle and the first external device or provided between the vehicle and the second external device;
a detection value of a signal transmitted by the PLC communication detected in the electric power channel provided between the vehicle and the first external device or provided between the vehicle and the second external device;
a detection value of a control signal representing a condition of fit of a connector that connects the vehicle with the first external device or the second external device, the detection value being detected in a signal channel provided between the vehicle and the first external device or provided between the vehicle and the second external device;
a detection value of a control signal representing a connecting condition of a cable that connects the first external device with the vehicle, the detection value being detected in the signal channel provided between the vehicle and the first external device or provided between the vehicle and the second external device;
a detection value of a control signal representing a feasibility of supplying electric power from the first external device to the vehicle, the detection value being detected in the signal channel provided between the vehicle and the first external device or provided between the vehicle and the second external device; and
a detection value of a control signal representing a rated current of the first external device, the detection value being detected in the signal channel provided between the vehicle and the first external device or provided between the vehicle and the second external device, wherein the operating mode includes a third operating mode, which is not the charging mode nor the supplying mode, **characterized in that** the third operating mode is a power stop mode in which neither the charging mode nor the supplying mode is implemented wherein the identifying system is further configured to determining that the operating mode of the charging/ supplying system is a power stop mode when the voltage applied from the first external device to the vehicle is not detected.

8. The identifying system according to claim 7, wherein
the control signal representing the condition of fit of the connector is a cable connection signal which is compliant with a J1772 standard established by the SAE; and/or
the control signal representing the connecting condition of the cable that connects the first external device with the vehicle, the feasibility of supplying electric power from the first external device to the vehicle, or the rated current of the first external device is a CPLT signal.

9. The identifying system according to claim 8, wherein the plurality of detection values include the detection value corresponding to the presence or absence of the voltage applied from the first external device to the vehicle, a detection value of the cable connection signal which is compliant with a J1772 standard established by the SAE, and a detection value of the CPLT signal.

10. The identifying system according to claim 8, wherein the plurality of detection values include the detection value corresponding to the presence or absence of the voltage applied from the first external device to the vehicle, the detection value corresponding to the presence or absence of the PLC communication the detection value of the signal transmitted by the PLC communication, a detection value of the cable connection signal which is compliant with a J1772 standard established by the SAE, and a detection value of the CPLT signal.

11. The identifying system according to claim 8, wherein the correspondence relationship is a relationship between each of the various combinations of the plurality of detection values and the operating mode of the charging/supplying system, which are determined in advance and stored in a data storage device.

12. The identifying system according to one of the claims 8 to 11, wherein one of the detection values is an impedance of the cable connection signal channel.

## Patentansprüche

1. Identifizierungsverfahren zum Identifizieren eines Betriebsmodus eines Lade-/Versorgungssystems, mit:
Erfassen einer Vielzahl von Erkennungswerten von mindestens einem elektrischen Verbindungskanal, der zwischen einem Fahrzeug und einer ersten externen Vorrichtung ausgebildet ist oder zwischen dem Fahrzeug und einer zweiten externen Vorrichtung über einen Verbindungsabschnitt ausgebildet ist, in dem Lade-/Versorgungssystem, in dem das Fahrzeug mit der ersten externen Vorrichtung oder über den Verbindungsabschnitt mit der zweiten externen Vorrichtung verbunden ist, das in einem Lademodus und einem Versorgungsmodus gemeinsam verwendet wird, wobei der Lademodus ein Modus ist, in dem eine an dem Fahrzeug installierte elektrische Speichervorrichtung mit elektrischer Energie von der ersten externen Vorrichtung zu der elektrischen Speichervorrichtung geladen wird, wobei der Versorgungsmodus ein Modus ist, in dem elektrische Energie von dem Fahrzeug zu der zweiten externen Vorrichtung geliefert wird, wobei das Lade-/Versorgungssystem konfiguriert ist, um in einem ausgewählten von dem Lademodus und dem Versorgungsmodus betrieben zu werden; und
Bestimmen, ob der Betriebsmodus des Lade-/Versorgungssystems der Lademodus oder der Versorgungsmodus ist, basierend auf einer Korrespondenzbeziehung zwischen der Vielzahl von Erkennungswerten und dem Betriebsmodus des Lade-/Versorgungssystems, wobei die Vielzahl von Erkennungswerten mindestens zwei Erkennungswerte beinhaltet, die ausgewählt sind aus:
einem Erkennungswert, der dem Vorhandensein oder Nichtvorhandensein einer von der ersten externen Vorrichtung an das Fahrzeug angelegten Spannung entspricht, wobei der Erkennungswert in einem zwischen dem Fahrzeug und der ersten externen Vorrichtung vorgesehenen Stromkanal oder in einem zwischen dem Fahrzeug und der zweiten externen Vorrichtung vorgesehenen Stromkanal detektiert wird;
einem Erkennungswert, der dem Vorhandensein oder Nichtvorhandensein einer PLC-Kommunikation entspricht, die in dem Stromkanal detektiert wird, der zwischen dem Fahrzeug und der ersten externen Vorrichtung vorgesehen ist oder zwischen dem Fahrzeug und der zweiten externen Vorrichtung vorgesehen ist;
einem Erkennungswert eines Signals, das von der PLC-Kommunikation übertragen wird, die in dem Stromkanal detektiert wird, der zwischen dem Fahrzeug und der ersten externen Vorrichtung vorgesehen ist oder zwischen dem Fahrzeug und der zweiten externen Vorrichtung vorgesehen ist;
einem Erkennungswert eines Steuersignals, das einen Verbindungszustand eines Verbinders darstellt, der das Fahrzeug mit der ersten externen Vorrichtung oder der zweiten externen Vorrichtung verbindet, wobei der Erfassungswert in einem Signalkanal detektiert wird, der zwischen dem Fahrzeug und der ersten externen Vorrichtung vorgesehen ist oder zwischen dem Fahrzeug und der zweiten externen Vorrichtung vorgesehen ist;
einem Erkennungswert eines Steuersignals, das einen Verbindungszustand eines Kabels darstellt, das die erste externe Vorrichtung mit dem Fahrzeug verbindet, wobei der Erkennungswert in dem Signalkanal detektiert wird, der zwischen dem Fahrzeug und der ersten externen Vorrichtung vorgesehen ist oder zwischen dem Fahrzeug und der zweiten externen Vorrichtung vorgesehen ist;
einem Erkennungswert eines Steuersignals, das eine Durchführbarkeit der Zufuhr von Strom von der ersten externen Vorrichtung zu dem Fahrzeug darstellt, wobei der Erkennungswert in dem Signalkanal detektiert wird, der zwischen dem Fahrzeug und der ersten externen Vorrichtung vorgesehen ist oder zwischen dem Fahrzeug und der zweiten externen Vorrichtung vorgesehen ist; und
einem Erkennungswert eines Steuersignals, das einen Nennstrom der ersten externen Vorrichtung darstellt, wobei der Erkennungswert in dem Signalkanal detektiert wird, der zwischen dem Fahrzeug und der ersten externen Vorrichtung vorgesehen ist oder zwischen dem Fahrzeug und der zweiten externen Vorrichtung vorgesehen ist, wobei der Betriebsmodus einen dritten Betriebsmodus umfasst, wobei der Betriebsmodus einen dritten Betriebsmodus umfasst, der weder der Lademodus noch der Versorgungsmodus ist, **dadurch gekennzeichnet, dass**
der dritte Betriebsmodus ein Leistungsstoppmodus ist, in dem weder der Lademodus noch der Versorgungsmodus implementiert ist, wobei das Identifizierungsverfahren ferner den Schritt des Bestimmens umfasst, dass der Betriebsmodus des Lade-/Versorgungssystems ein Leistungsstoppmodus ist, wenn die von der ersten externen Vorrichtung an das Fahrzeug angelegte Spannung nicht erfasst wird.

2. Identifizierungsverfahren nach Anspruch 1, wobei
das Steuersignal, das den Verbindungszustand des Verbinders darstellt, ein Kabelverbindungssignal ist, das mit einem von der SAE festgelegten J1772-Standard konform ist; und/oder
das Steuersignal, das den Verbindungszustand des Kabels, das die erste externe Vorrichtung mit dem Fahrzeug verbindet, die Möglichkeit der Versorgung des Fahrzeugs mit elektrischer Energie von der ersten externen Vorrichtung oder den Nennstrom der ersten externen Vorrichtung darstellt, ein CPLT-Signal ist.

3. Identifizierungsverfahren nach Anspruch 2, wobei die Vielzahl von Erkennungswerten den Erkennungswert, der dem Vorhandensein oder Nichtvorhandensein der von der ersten externen Vorrichtung an das Fahrzeug angelegten Spannung entspricht, einen Erkennungswert des Kabelverbindungssignals, das mit einem von der SAE festgelegten J1772-Standard konform ist, und einen Erkennungswert des CPLT-Signals beinhaltet.

4. Identifizierungsverfahren nach Anspruch 2, wobei die Vielzahl von Erkennungswerten den Erkennungswert, der dem Vorhandensein oder Nichtvorhandensein der von der ersten externen Vorrichtung an das Fahrzeug angelegten Spannung entspricht, den Erkennungswert, der dem Vorhandensein oder Nichtvorhandensein der PLC-Kommunikation entspricht, den Erkennungswert des von der PLC-Kommunikation übertragenen Signals, einen Erkennungswert des Kabelverbindungssignals, das mit einem von der SAE festgelegten J1772-Standard konform ist, und einen Erkennungswert des CPLT-Signals beinhaltet.

5. Identifizierungsverfahren nach Anspruch 1, wobei die Korrespondenzbeziehung eine Beziehung zwischen jeder der verschiedenen Kombinationen der Vielzahl von Erkennungswerten und dem Betriebsmodus des Lade-/Versorgungssystems ist, die im Voraus bestimmt und in einer Datenspeichereinrichtung gespeichert werden.

6. Identifizierungsverfahren nach einem der Ansprüche 1 bis 5, wobei einer der Erkennungswerte eine Impedanz des Kabelverbindungssignalkanals ist.

7. Identifizierungssystem zum Identifizieren eines Betriebsmodus eines Lade-/Versorgungssystems mit:
einen Verbinder, der so konfiguriert ist, dass er ein Fahrzeug mit einer ersten externen Vorrichtung oder einer zweiten externen Vorrichtung über einen Verbindungsabschnitt verbindet, der gemeinsam in einem Lademodus und einem Versorgungsmodus verwendet wird, wobei der Lademodus ein Modus ist, in dem eine an dem Fahrzeug installierte elektrische Speichervorrichtung mit elektrischer Energie von der ersten externen Vorrichtung zu der elektrischen Speichervorrichtung geladen wird, und der Versorgungsmodus ein Modus ist, in dem elektrische Energie von dem Fahrzeug zu der zweiten externen Vorrichtung geliefert wird;
einen Detektor, der so konfiguriert ist, dass er eine Vielzahl von Erkennungswerten von zumindest einem elektrischen Verbindungskanal erfasst, der zwischen dem Fahrzeug und der ersten externen Vorrichtung ausgebildet ist oder zwischen dem Fahrzeug und der zweiten externen Vorrichtung über den Verbindungsabschnitt ausgebildet ist; und
eine Identifizierungsvorrichtung, die konfiguriert ist, um zu bestimmen, ob der Betriebsmodus des Lade-/Versorgungssystems der Lademodus oder der Versorgungsmodus ist, basierend auf einer Korrespondenzbeziehung zwischen der Vielzahl von Erkennungswerten und dem Betriebsmodus des Lade-/Versorgungssystems, wobei die Vielzahl von Erkennungswerten mindestens zwei Erkennungswerte umfasst, die ausgewählt sind aus:
einen Erkennungswert, der dem Vorhandensein oder Nichtvorhandensein einer von der ersten externen Vorrichtung an das Fahrzeug angelegten Spannung entspricht, wobei der Erkennungswert in einem zwischen dem Fahrzeug und der ersten externen Vorrichtung oder zwischen dem Fahrzeug und der zweiten externen Vorrichtung vorgesehenen Stromkanal erfasst wird;
einen Erkennungswert, der dem Vorhandensein oder Nichtvorhandensein einer PLC-Kommunikation entspricht, die in dem elektrischen Stromkanal erfasst wird, der zwischen dem Fahrzeug und der ersten externen Vorrichtung vorgesehen ist oder zwischen dem Fahrzeug und der zweiten externen Vorrichtung vorgesehen ist;
einen Erkennungswert eines Signals, das durch die PLC-Kommunikation übertragen wird, die in dem elektrischen Stromkanal erfasst wird, der zwischen dem Fahrzeug und der ersten externen Vorrichtung ausgebildet ist oder zwischen dem Fahrzeug und der zweiten externen Vorrichtung ausgebildet ist;
einen Erkennungswert eines Steuersignals, das einen Zustand des Sitzes eines Verbinders darstellt, der das Fahrzeug mit der ersten externen Vorrichtung oder der zweiten externen Vorrichtung verbindet, wobei der Erkennungswert in einem Signalkanal erfasst wird, der zwischen dem Fahrzeug und der ersten externen Vorrichtung oder zwischen dem Fahrzeug und der zweiten externen Vorrichtung vorgesehen ist;
einen Erkennungswert eines Steuersignals, das einen Verbindungszustand eines Kabels darstellt, das die erste externe Vorrichtung mit dem Fahrzeug verbindet, wobei der Erkennungswert in dem Signalkanal erfasst wird, der zwischen dem Fahrzeug und der ersten externen Vorrichtung ausgebildet ist oder zwischen dem Fahrzeug und der zweiten externen Vorrichtung ausgebildet ist;
einen Erkennungswert eines Steuersignals, das eine Durchführbarkeit der Zufuhr von elektrischer Energie von der ersten externen Vorrichtung zu dem Fahrzeug darstellt, wobei der Erkennungswert in dem Signalkanal erfasst wird, der zwischen dem Fahrzeug und der ersten externen Vorrichtung ausgebildet ist oder zwischen dem Fahrzeug und der zweiten externen Vorrichtung ausgebildet ist; und
einen Erkennungswert eines Steuersignals, das einen Nennstrom der ersten externen Vorrichtung darstellt, wobei der Erkennungswert in dem Signalkanal erfasst wird, der zwischen dem Fahrzeug und der ersten externen Vorrichtung ausgebildet ist oder zwischen dem Fahrzeug und der zweiten externen Vorrichtung ausgebildet ist, wobei der Betriebsmodus einen dritten Betriebsmodus beinhaltet, der weder der Lademodus noch der Versorgungsmodus ist, **dadurch gekennzeichnet, dass** der dritte Betriebsmodus ein Leistungsstoppmodus ist, in dem weder der Lademodus noch der Versorgungsmodus implementiert ist, wobei das Identifizierungssystem ferner konfiguriert ist, um zu bestimmen, dass der Betriebsmodus des Lade-/Versorgungssystems ein Leistungsstoppmodus ist, wenn die von der ersten externen Vorrichtung an das Fahrzeug angelegte Spannung nicht erfasst wird.

8. Identifizierungssystem nach Anspruch 7, wobei
das Steuersignal, das den Verbindungszustand des Verbinders darstellt, ein Kabelverbindungssignal ist, das mit einem von der SAE festgelegten J1772-Standard konform ist; und/oder
das Steuersignal, das den Verbindungszustand des Kabels, das die erste externe Vorrichtung mit dem Fahrzeug verbindet, die Möglichkeit der Versorgung des Fahrzeugs mit elektrischer Energie von der ersten externen Vorrichtung oder den Nennstrom der ersten externen Vorrichtung darstellt, ein CPLT-Signal ist.

9. Identifizierungssystem nach Anspruch 8, wobei die Vielzahl von Erkennungswerten den Erkennungswert, der dem Vorhandensein oder Nichtvorhandensein der von der ersten externen Vorrichtung an das Fahrzeug angelegten Spannung entspricht, einen Erkennungswert des Kabelverbindungssignals, das mit einem von der SAE festgelegten J1772-Standard konform ist, und einen Erkennungswert des CPLT-Signals beinhalten.

10. Identifizierungssystem nach Anspruch 8, wobei die Vielzahl von Erkennungswerten den Erkennungswert, der dem Vorhandensein oder Nichtvorhandensein der von der ersten externen Vorrichtung an das Fahrzeug angelegten Spannung entspricht, den Erkennungswert, der dem Vorhandensein oder Nichtvorhandensein der PLC-Kommunikation entspricht, den Erkennungswert des von der PLC-Kommunikation übertragenen Signals, einen Erkennungswert des Kabelverbindungssignals, das mit einem von der SAE festgelegten J1772-Standard konform ist, und einen Erkennungswert des CPLT-Signals beinhaltet.

11. Identifizierungssystem nach Anspruch 8, wobei die Korrespondenzbeziehung eine Beziehung zwischen jeder der verschiedenen Kombinationen der Vielzahl von Erkennungswerten und dem Betriebsmodus des Lade-/Versorgungssystems ist, die im Voraus bestimmt und in einer Datenspeichereinrichtung gespeichert werden.

12. Identifizierungssystem nach einem der Ansprüche 8 bis 11, wobei einer der Erkennungswerte eine Impedanz des Kabelverbindungssignalkanals ist.

## Revendications

1. Procédé d'identification destiné à identifier un mode de fonctionnement d'un système de charge/alimentation, comprenant le fait de :
détecter une pluralité de valeurs de détection à partir de au moins un canal de connexion électrique prévu entre un véhicule et un premier dispositif externe ou prévu entre le véhicule et un second dispositif externe par l'intermédiaire d'une partie de connexion, dans le système de charge/alimentation dans lequel le véhicule est relié au premier dispositif externe ou au second dispositif externe par l'intermédiaire de la partie de connexion utilisée en commun dans un mode de charge et un mode d'alimentation, le mode de charge étant un mode dans lequel un dispositif de stockage électrique installé sur le véhicule est chargé avec de l'énergie électrique depuis le premier dispositif externe jusqu'au dispositif de stockage électrique, le mode d'alimentation étant un mode dans lequel de l'énergie électrique est délivrée depuis le véhicule jusqu'au second dispositif externe, le système de charge/alimentation étant configuré pour être mis en oeuvre dans l'un sélectionné du mode de charge et du mode alimentation ; et
déterminer si le mode de fonctionnement du système de charge/alimentation est le mode de charge ou le mode d'alimentation, sur la base d'une relation de correspondance entre la pluralité de valeurs de détection et le mode de fonctionnement du système de charge/alimentation, dans lequel la pluralité de valeurs de détection inclut au moins deux valeurs de détection sélectionnées parmi :
une valeur de détection correspondant à la présence ou à l'absence d'une tension appliquée depuis le premier dispositif externe jusqu'au véhicule, la valeur de détection étant détectée dans un canal d'énergie électrique prévu entre le véhicule et le premier dispositif externe ou prévu entre le véhicule et le second dispositif externe ;
une valeur de détection correspondant à la présence ou à l'absence de communication à courant porteur en ligne détectée dans le canal d'énergie électrique prévu entre le véhicule et le premier dispositif externe ou prévu entre le véhicule et le second dispositif externe ;
une valeur de détection d'un signal transmis par la communication à courant porteur en ligne détectée dans le canal d'énergie électrique prévu entre le véhicule et le premier dispositif externe ou prévu entre le véhicule et le second dispositif externe ;
une valeur de détection d'un signal de commande représentant une condition de montage d'un connecteur qui relie le véhicule au premier dispositif externe ou au second dispositif externe, la valeur de détection étant détectée dans un canal de signal prévu entre le véhicule et le premier dispositif externe ou prévu entre le véhicule et le second dispositif externe ;
une valeur de détection d'un signal de commande représentant une condition de connexion d'un câble qui relie le premier dispositif externe au véhicule, la valeur de détection étant détectée dans le canal de signal prévu entre le véhicule et le premier dispositif externe ou prévu entre le véhicule et le second dispositif externe ;
une valeur de détection d'un signal de commande représentant une faisabilité d'alimentation en énergie électrique depuis le premier dispositif externe jusqu'au véhicule, la valeur de détection étant détectée dans le canal de signal prévu entre le véhicule et le premier dispositif externe ou prévu entre le véhicule et le second dispositif externe ; et
une valeur de détection d'un signal de commande représentant un courant nominal du premier dispositif externe, la valeur de détection étant détectée dans le canal de signal prévu entre le véhicule et le premier dispositif externe ou prévu entre le véhicule et le second dispositif externe, dans lequel le mode de fonctionnement inclut un troisième mode de fonctionnement, qui n'est ni le mode de charge ni le mode d'alimentation, **caractérisé en ce que** le troisième mode de fonctionnement est un mode d'arrêt de puissance, dans lequel ni le mode de charge ni le mode d'alimentation n'est mis en oeuvre, dans lequel le procédé d'identification comprend en outre l'étape consistant à déterminer que le mode de fonctionnement du système de charge/alimentation est un mode d'arrêt de puissance lorsque la tension appliquée depuis le premier dispositif externe jusqu'au véhicule n'est pas détectée.

2. Procédé d'identification selon la revendication 1, dans lequel
le signal de commande représentant la condition de montage du connecteur est un signal de connexion de câble qui est conforme à une norme J1772 établie par le SAE; et/ou
le signal de commande représentant la condition de connexion du câble qui relie le premier dispositif externe au véhicule, la faisabilité d'alimentation en énergie électrique depuis le premier dispositif externe jusqu'au véhicule, ou le courant nominal du premier dispositif externe est un signal pilote.

3. Procédé d'identification selon la revendication 2, dans lequel la pluralité de valeurs de détection inclut la valeur de détection correspondant à la présence ou à l'absence de tension appliquée depuis le premier dispositif externe jusqu'au véhicule, une valeur de détection du signal de connexion de câble qui est conforme à une norme J1772 établie par le SAE, et une valeur de détection du signal pilote.

4. Procédé d'identification selon la revendication 2, dans lequel la pluralité de valeurs de détection inclut la valeur de détection correspondant à la présence ou à l'absence de tension appliquée depuis le premier dispositif externe jusqu'au véhicule, la valeur de détection correspondant à la présence ou à l'absence de la communication à courant porteur en ligne, la valeur de détection du signal transmis par la communication à courant porteur en ligne, une valeur de détection du signal de connexion de câble qui est conforme à une norme J1772 établie par le SAE, et une valeur de détection du signal pilote.

5. Procédé d'identification selon la revendication 1, dans lequel la relation de correspondance est une relation entre chacune des diverses combinaisons de la pluralité de valeurs de détection et le mode de fonctionnement du système de charge/alimentation, qui sont déterminées à l'avance et stockées dans un dispositif de stockage de données.

6. Procédé d'identification selon l'une des revendications 1 à 5, dans lequel l'une des valeurs de détection est une impédance du canal de signal de connexion de câble.

7. Système d'identification destiné à identifier un mode de fonctionnement d'un système de charge/alimentation, le système d'identification comprenant :
un connecteur configuré pour relier un véhicule à un premier dispositif externe ou à un second dispositif externe par l'intermédiaire d'une partie de connexion utilisée en commun dans un mode de charge et un mode d'alimentation, le mode de charge étant un mode dans lequel un dispositif de stockage électrique installé sur le véhicule est chargé avec de l'énergie électrique depuis le premier dispositif externe jusqu'au dispositif de stockage électrique et le mode d'alimentation étant un mode dans lequel de l'énergie électrique est délivrée depuis le véhicule jusqu'au second dispositif externe ;
un détecteur configuré pour détecter une pluralité de valeur de détection à partir de au moins un canal de connexion électrique prévu entre le véhicule et le premier dispositif externe ou prévu entre le véhicule et le second dispositif externe par l'intermédiaire d'une partie de connexion ; et
un dispositif d'identification configuré pour déterminer si le mode de fonctionnement du système de charge/alimentation est le mode de charge ou le mode d'alimentation, sur la base d'une relation de correspondance entre la pluralité de valeurs de détection et le mode de fonctionnement du système de charge/alimentation, dans lequel la pluralité de valeurs de détection inclut au moins deux valeurs de détection sélectionnées parmi :
une valeur de détection correspondant à la présence ou à l'absence d'une tension appliquée depuis le premier dispositif externe jusqu'au véhicule, la valeur de détection étant détectée dans un canal d'énergie électrique prévu entre le véhicule et le premier dispositif externe ou prévu entre le véhicule et le second dispositif externe ;
une valeur de détection correspondant à la présence ou à l'absence de communication à courant porteur en ligne détectée dans le canal d'énergie électrique prévu entre le véhicule et le premier dispositif externe ou prévu entre le véhicule et le second dispositif externe ;
une valeur de détection d'un signal transmis par la communication à courant porteur en ligne détectée dans le canal d'énergie électrique prévu entre le véhicule et le premier dispositif externe ou prévu entre le véhicule et le second dispositif externe ;
une valeur de détection d'un signal de commande représentant une condition de montage d'un connecteur qui relie le véhicule au premier dispositif externe ou au second dispositif externe, la valeur de détection étant détectée dans un canal de signal prévu entre le véhicule et le premier dispositif externe ou prévu entre le véhicule et le second dispositif externe ;
une valeur de détection d'un signal de commande représentant une condition de connexion d'un câble qui relie le premier dispositif externe au véhicule, la valeur de détection étant détectée dans le canal de signal prévu entre le véhicule et le premier dispositif externe ou prévu entre le véhicule et le second dispositif externe ;
une valeur de détection d'un signal de commande représentant une faisabilité d'alimentation en énergie électrique depuis le premier dispositif externe jusqu'au véhicule, la valeur de détection étant détectée dans le canal de signal prévu entre le véhicule et le premier dispositif externe ou prévu entre le véhicule et le second dispositif externe ; et
une valeur de détection d'un signal de commande représentant un courant nominal du premier dispositif externe, la valeur de détection étant détectée dans le canal de signal prévu entre le véhicule et le premier dispositif externe ou prévu entre le véhicule et le second dispositif externe, dans lequel le mode de fonctionnement inclut un troisième mode de fonctionnement, qui n'est ni le mode de charge ni le mode d'alimentation, **caractérisé en ce que** le troisième mode de fonctionnement est un mode d'arrêt dans lequel ni le mode de charge ni le mode d'alimentation n'est mis en oeuvre, dans lequel la procédé d'identification est en outre configuré pour déterminer que le mode de fonctionnement du système de charge/alimentation est un mode d'arrêt lorsque la tension appliquée depuis le premier dispositif externe jusqu'au véhicule n'est pas détectée.

8. Système d'identification selon la revendication 7, dans lequel
le signal de commande représentant la condition de montage du connecteur est un signal de connexion de câble qui est conforme à une norme J1772 établie par le SAE; et/ou
le signal de commande représentant la condition de connexion du câble qui relie le premier dispositif externe au véhicule, la faisabilité d'alimentation en énergie électrique depuis le premier dispositif externe jusqu'au véhicule, ou le courant nominal du premier dispositif externe est un signal pilote.

9. Système d'identification selon la revendication 8, dans lequel la pluralité de valeurs de détection inclut la valeur de détection correspondant à la présence ou à l'absence de tension appliquée depuis le premier dispositif externe jusqu'au véhicule, une valeur de détection du signal de connexion de câble qui est conforme à une norme J1772 établie par le SAE, et une valeur de détection du signal pilote.

10. Système d'identification selon la revendication 8, dans lequel la pluralité de valeurs de détection inclut la valeur de détection correspondant à la présence ou à l'absence de tension appliquée depuis le premier dispositif externe jusqu'au véhicule, la valeur de détection correspondant à la présence ou à l'absence de la communication à courant porteur en ligne, une valeur de détection du signal de connexion de câble qui est conforme à la norme J1772 établie par le SAE, et une valeur de détection du signal pilote.

11. Système d'identification selon la revendication 8, dans lequel la relation de correspondance est une relation entre chacune des combinaisons de la pluralité de valeurs de détection et le mode de fonctionnement du système de charge/alimentation, qui sont déterminées à l'avance et stockées dans un dispositif de stockage de données.

12. Système d'identification selon l'une des revendications 8 à 11, dans lequel l'une des valeurs de détection est une impédance du canal de signal de connexion de câble.
